# EUROPEAN PATENT APPLICATION

(11) **EP 4 415 498 A2**
(43) Date of publication of application: **14.08.2024**
(21) Application number: 23220660.7
(22) Date of filing: 28.12.2023
(51) Int. Cl.: H10B 12/00

(54) **SEMICONDUCTOR DEVICES**

(30) Priority: 17.01.2023 KR 20230006510
(71) Applicant: Samsung Electronics Co., Ltd., Suwon-si, Gyeonggi-do 16677 (KR)
(72) Inventor: CHOI, Gaeun, 16677 Suwon-si (KR); CHOI, Wooyoung, 16677 Suwon-si (KR); YOON, Chansic, 16677 Suwon-si (KR)
(74) Representative: Marks & Clerk LLP

(57) **Abstract**

A semiconductor device includes: an active pattern on a substrate; a gate structure in an upper portion of the active pattern; a bit line structure on the active pattern; a spacer structure on a sidewall of the bit line structure, the spacer structure including an insulating material; and a lower contact plug on a portion of the active pattern adjacent to the bit line structure, the lower contact plug contacting the spacer structure, wherein the spacer structure includes a layer having at least two curves and a vertex disposed between and contacting the two curves.

## Description

### 1. Field

Embodiments of the present disclosure relate to semiconductor devices and methods of manufacturing the same. More particularly, embodiments of the present disclosure relate to dynamic random-access memory (DRAM) devices and methods of manufacturing the same.

### 2. Description of Related Art

In a method of manufacturing a DRAM device, a spacer structure may be formed on a sidewall of a bit line structure that may contact an upper surface of a central portion of an active pattern, a contact plug may be formed between the spacer structures to contact an upper surface of each of opposite edge portions of the active pattern, and a capacitor may be formed on the contact plug to be electrically connected thereto.

As the integration degree of the DRAM device increases, the distance between the spacer structures may decrease. Thus, the difficulty of the process of forming the contact plug may increase.

### SUMMARY

Example embodiments provide a semiconductor device having improved electrical characteristics.

Example embodiments provide a method of manufacturing a semiconductor device having improved electrical characteristics.

According to embodiments, there is provided a semiconductor device. The semiconductor device includes, an active pattern on a substrate; a gate structure in an upper portion of the active pattern; a bit line structure on the active pattern; a spacer structure on a sidewall of the bit line structure, the spacer structure including an insulating material; and a lower contact plug on a portion of the active pattern adjacent to the bit line structure, the lower contact plug contacting the spacer structure, wherein the spacer structure includes a layer having at least two curves and a vertex disposed between and contacting the two curves.

According to embodiments, there is provided a semiconductor device. The semiconductor device may include: an active pattern on a substrate; a gate structure in an upper portion of the active pattern; a bit line structure on the active pattern; a spacer structure on a sidewall of the bit line structure, the spacer structure including an insulating material; and a lower contact plug on a portion of the active pattern adjacent to the bit line structure, the lower contact plug contacting the spacer structure, wherein the spacer structure includes a layer having a vertex at which a slope non-linearly changes.

According to embodiments, there is provided a semiconductor device. The semiconductor device may include: active patterns on a substrate, the active patterns disposed in first and second directions substantially parallel to an upper surface of the substrate and substantially perpendicular to each other; an isolation pattern covering sidewalls of the active patterns; gate structures spaced apart from each other in the second direction, each of the gate structures formed in upper portions of the active patterns and the isolation pattern and extending in the first direction; bit line structures spaced apart from each other in the first direction, each of the bit line structures being on central portions of ones of the active patterns arranged in the second direction and extending in the second direction; a spacer structure on a sidewall in the first direction of each of the bit line structures, the spacer structure including first, second and third spacers sequentially stacked in the first direction; and a contact plug structure on each of end portions of each of the active patterns, the contact plug comprising a lower contact plug and an upper contact plug sequentially stacked in a vertical direction substantially perpendicular to an upper surface of the substrate, wherein the third spacer includes two curves and a vertex disposed between and contacting the two curves.

According to embodiments, there is provided a method of manufacturing a semiconductor device. The method of manufacturing the semiconductor device include: forming active patterns on a substrate in first and second directions substantially parallel to an upper surface of the substrate and substantially perpendicular to each other; forming gate structures spaced apart from each other in the second direction, each of the gate structures buried in an upper portion of the active patterns and extending in the first direction; forming bit line structures on ones of the active patterns disposed in the second direction to be spaced apart from each other in the first direction, each of the bit line structures extending in the second direction; forming spacer structures on sidewalls of the bit line structures, respectively; forming a sacrificial pattern between the spacer structures; doping ions into an upper portion of the sacrificial pattern; performing an etching process on the sacrificial pattern to form first openings spaced apart from each other in the second direction, the first openings exposing upper surfaces of corresponding ones of the gate structures, respectively; forming fence patterns in the first openings, respectively; removing the sacrificial pattern to form second openings, the second openings exposing upper surfaces of corresponding ones of the active patterns, respectively; and forming lower contact plugs in the second openings, respectively.

According to embodiments, there is provided a method of manufacturing a semiconductor device. The method of manufacturing the semiconductor device may include: forming active patterns on a substrate in first and second directions substantially parallel to an upper surface of the substrate and substantially perpendicular to each other; forming gate structures spaced apart from each other in the second direction, each of the gate structures buried in an upper portion of the active patterns and extending in the first direction; forming bit line structures on ones of the active patterns disposed in the second direction to be spaced apart from each other in the first direction, each of the bit line structures extending in the second direction; forming spacer structures on sidewalls of the bit line structures, respectively; forming protective spacers on sidewalls of the spacer structures, respectively; forming a sacrificial pattern between the protective spacers; performing an etching process on the sacrificial pattern to form first openings spaced apart from each other in the second direction, the first openings exposing upper surfaces of corresponding ones of the gate structures and the protective spacers, respectively; removing portions of the protective spacers exposed by the first openings; forming fence patterns in the first openings, respectively; removing the sacrificial pattern to form second openings, the second openings exposing upper surfaces of corresponding ones of the active patterns and the protective spacers, respectively; removing portions of the protective spacers exposed by the second openings; and forming lower contact plugs in the second openings, respectively.

According to embodiments, there is provided a method of manufacturing a semiconductor device. The method of manufacturing the semiconductor device includes: forming active patterns on a substrate in first and second directions substantially parallel to an upper surface of the substrate and substantially perpendicular to each other; forming gate structures spaced apart from each other in the second direction, each of the gate structures buried in an upper portion of the active patterns and extending in the first direction; forming bit line structures on ones of the active patterns disposed in the second direction to be spaced apart from each other in the first direction, each of the bit line structures extending in the second direction; forming spacer structures on sidewalls of the bit line structures, respectively; forming protective spacers on sidewalls of the spacer structures, respectively; forming a sacrificial pattern between the protective spacers; doping ions into an upper portion of the sacrificial pattern; performing an etching process on the sacrificial pattern to form first openings spaced apart from each other in the second direction, the first openings exposing upper surfaces of corresponding ones of the gate structures, respectively; forming fence patterns in the first openings, respectively; removing the sacrificial pattern to form second openings, the second openings exposing upper surfaces of corresponding ones of the active patterns, respectively; and forming lower contact plugs in the second openings, respectively.

In the method of manufacturing the semiconductor device in accordance with the embodiments, the protective spacer may be additionally formed on the outer sidewall of the spacer structure on the sidewall of the bit line structure. Accordingly, during the etching process of forming the fence pattern, the spacer structure may not be damaged, and thus, the spacer structure may not be formed to be excessively thick. Additionally, the opening for forming the fence pattern and/or the lower contact plug may increase, and thus the process of forming the fence pattern and/or the lower contact plug may be easily performed.

At least some of the above and other features of the invention are set out in the claims.

### BRIEF DESCRIPTION OF DRAWINGS

FIG. 1 is a plan view illustrating a semiconductor device, according to embodiments, FIGS. 2A and 2B are cross-sectional views taken along line A-A' and B-B' of FIG. 1, respectively, and FIGS. 3 and 4 are enlarged cross-sectional views of regions X and Y of FIGS. 2A and 2B, respectively.
FIGS. 5 to 27A-27B are plan views and cross-sectional views illustrating a method of manufacturing a semiconductor device, according to the embodiments.

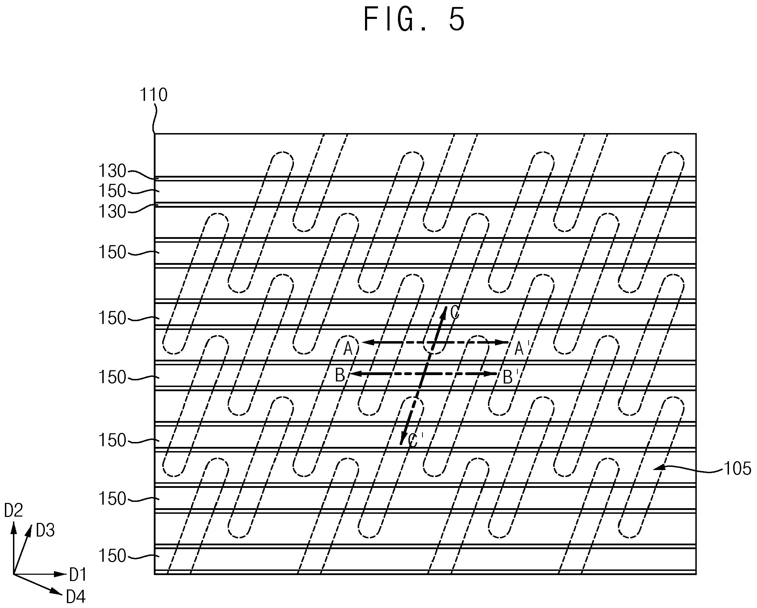

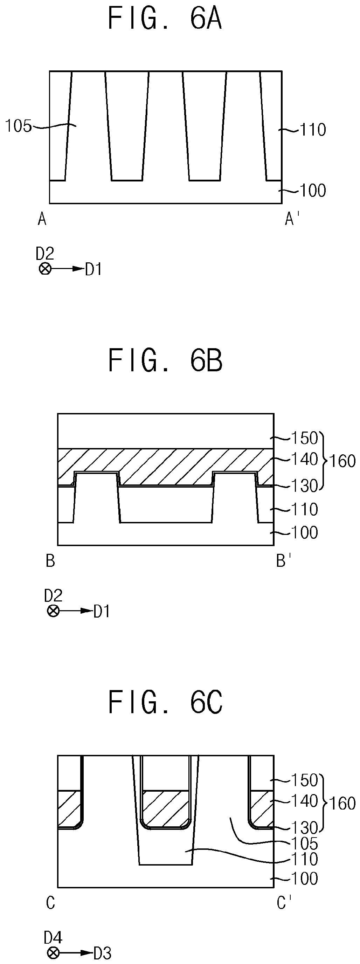

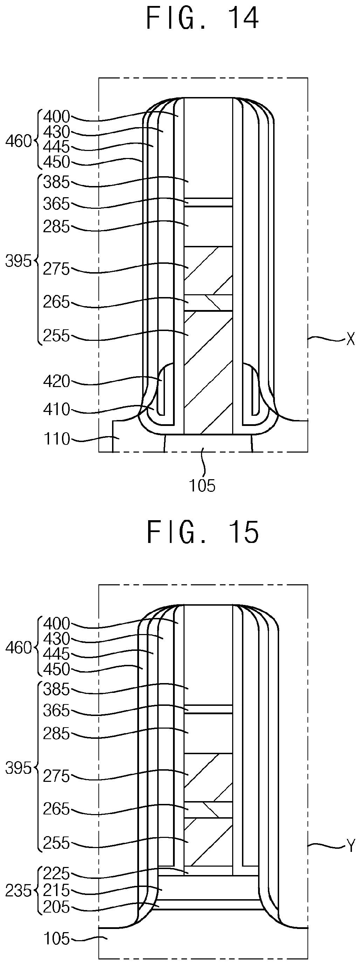

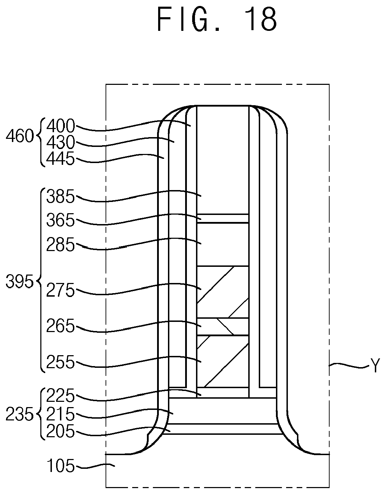

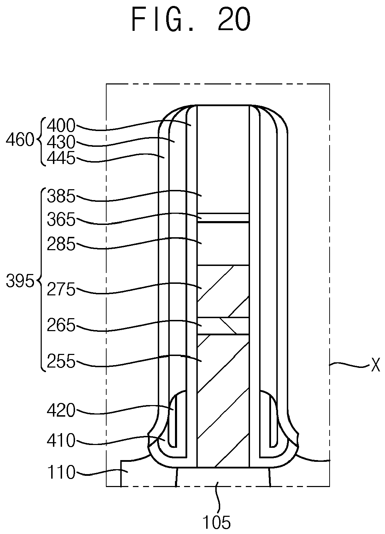

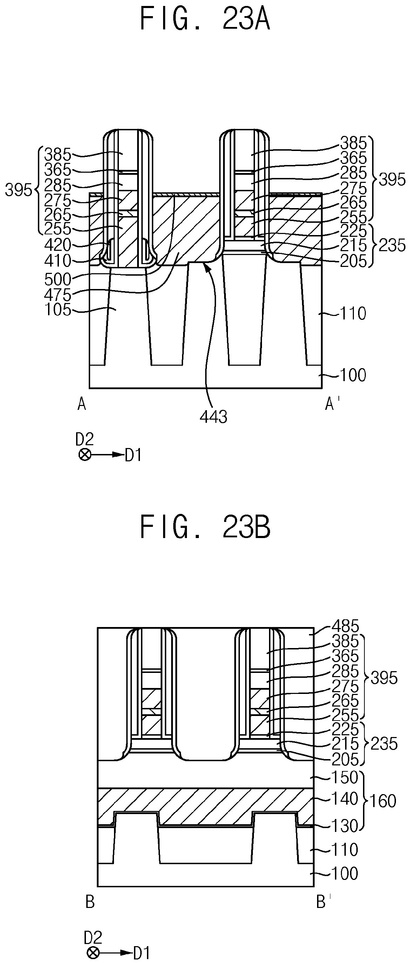

FIGS. 5, 7, 10, 21 and 25 are the plan views, and FIGS. 6A-6C, 8A-8C, 9A-9C, 11A-11C, 12A-12C, 13A-13C, 16A-16C, 17A-17C, 19A-19C and 22A-22C are cross-sectional views taken along lines A-A', B-B' and C-C' of corresponding plan views, respectively. FIGS.23A-23B, 24A-24B, 26A-26B and 27A-27B are cross-sectional views taken along lines A-A' and B-B' of corresponding plan views, respectively. FIGS. 14 and 20 are enlarged cross-sectional views of region X of corresponding plan views, respectively, and FIGS. 15 and 18 are enlarged cross-sectional views of region Y of corresponding plan views, respectively.

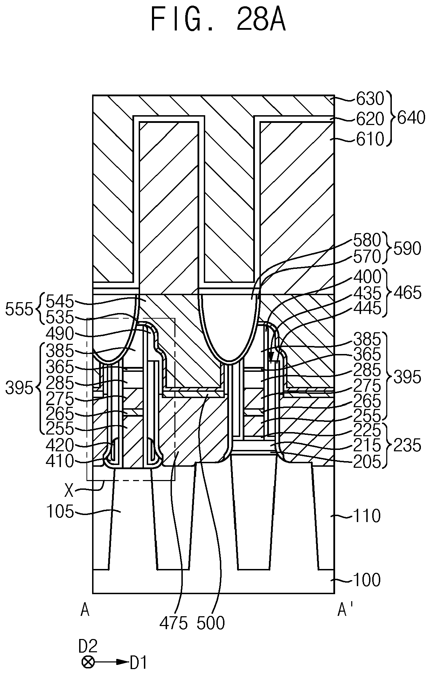

FIGS. 28A-28B to FIGS. 32A-32B are cross-sectional views illustrating semiconductor devices, according to embodiments.

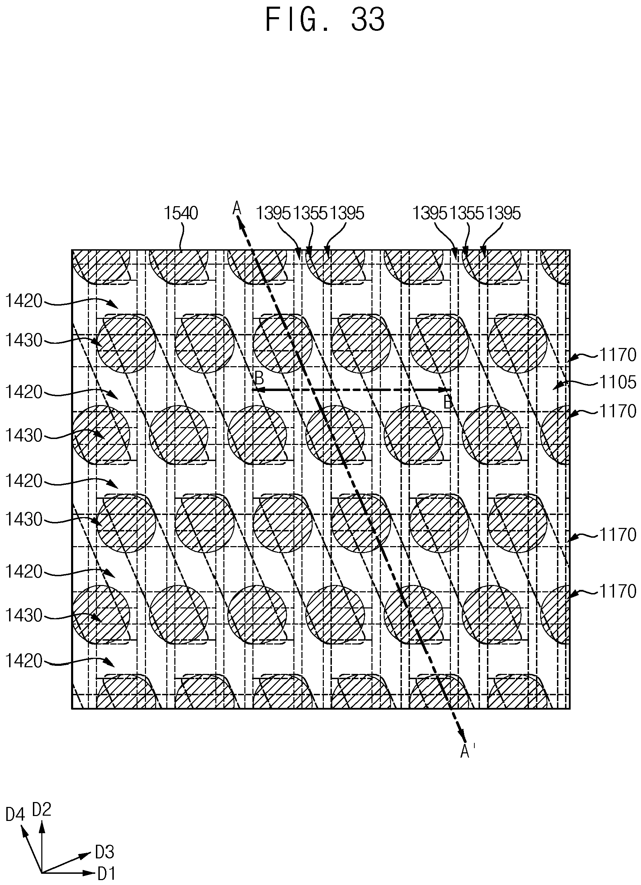

FIGS. 33 to 35 are a plan view and cross-sectional views illustrating semiconductor devices, according to embodiments.

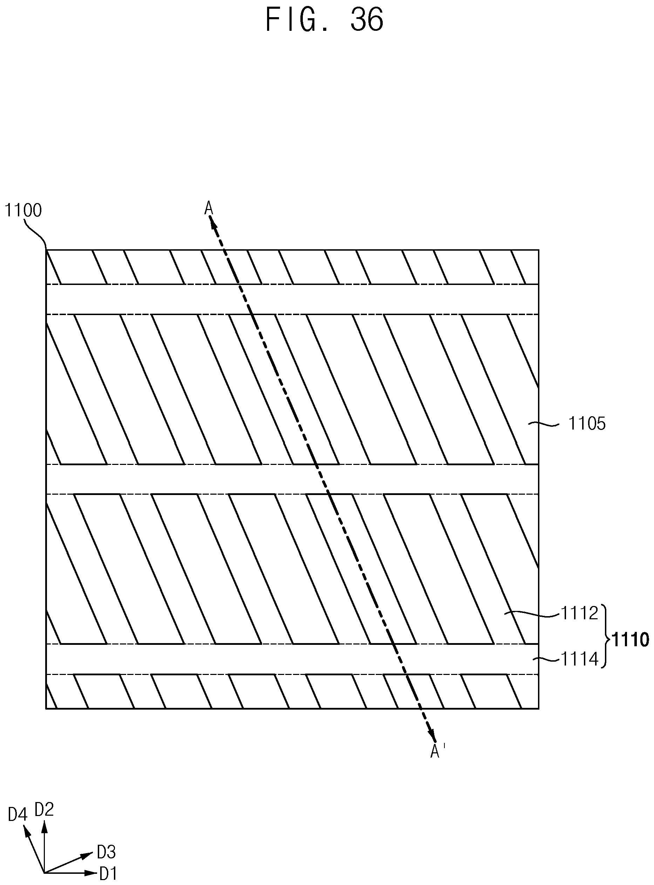

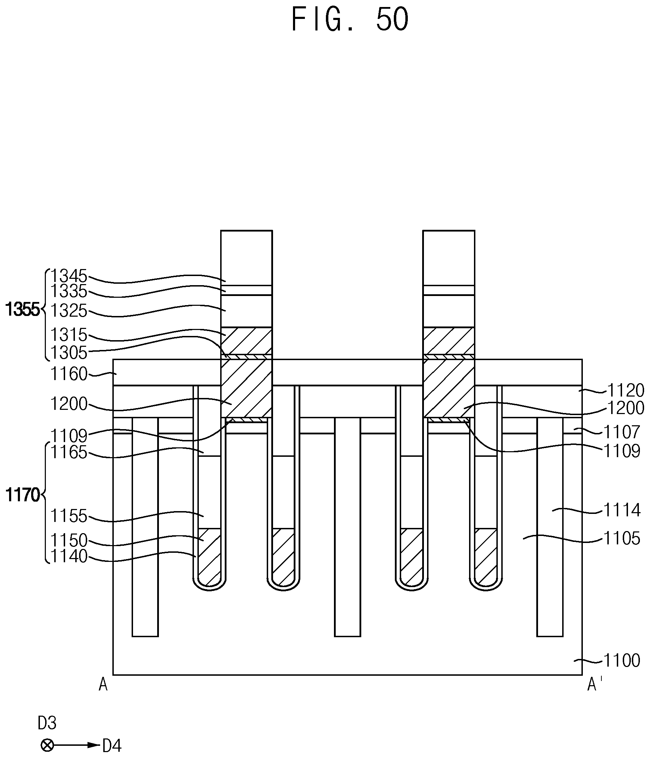

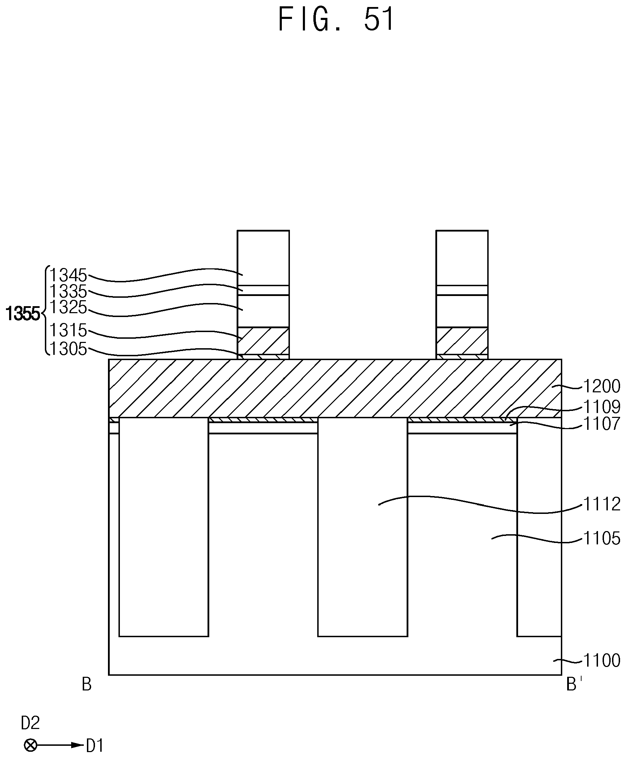

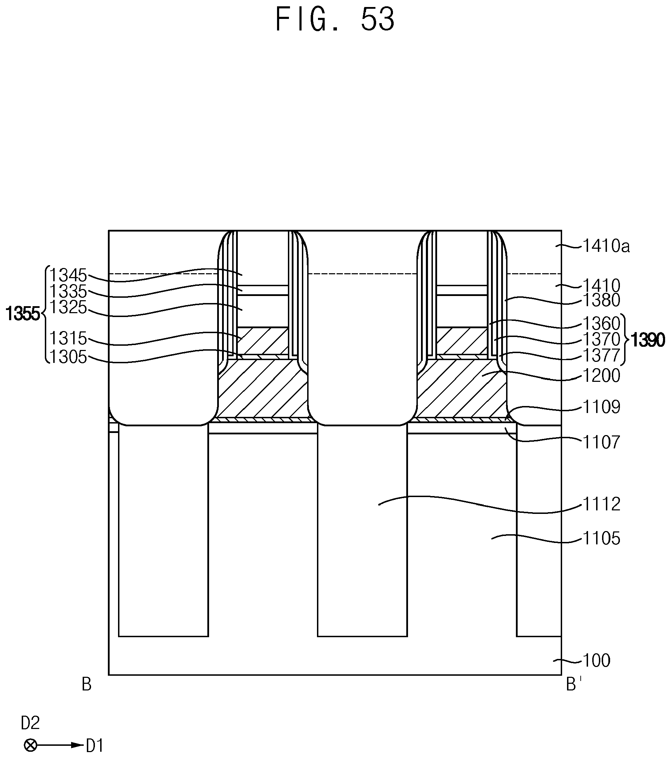

FIGS. 36 to 61 are plan views and cross-sectional views illustrating a method of manufacturing a semiconductor device, according to embodiments.

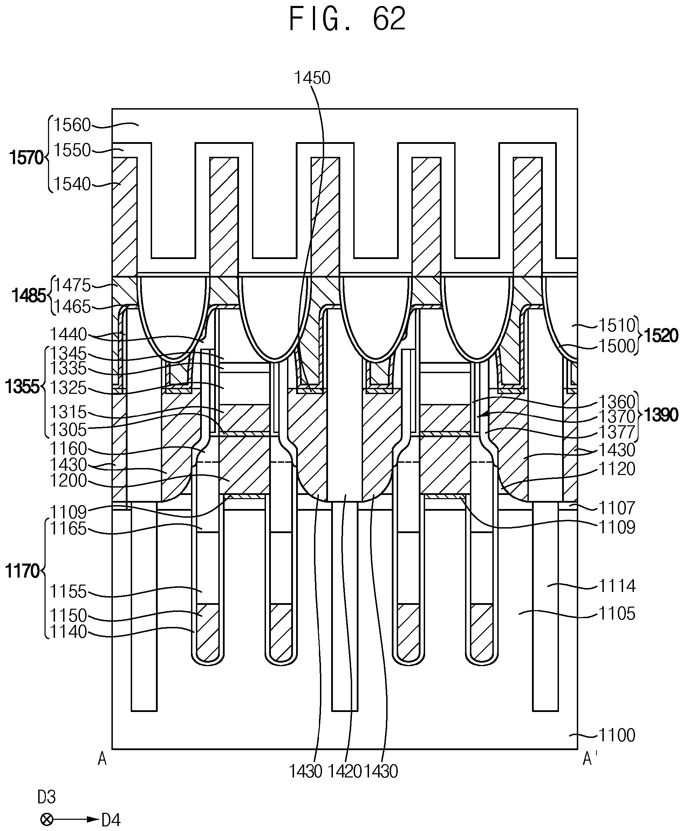

FIGS. 62 to 65 are cross-sectional views illustrating semiconductor devices, according to embodiments.

### DETAILED DESCRIPTION

The above and other aspects and features of the semiconductor devices and the methods of manufacturing the same according to embodiments will become readily understood from detail descriptions that follow, with reference to the accompanying drawings. The embodiments described herein are example embodiments, and thus, the disclosure is not limited thereto and may be realized in various other forms. It will be understood that, although the terms "first," "second," and/or "third" may be used herein to describe various materials, layers, regions, electrodes, pads, patterns, structure and/or processes, these various materials, layers, regions, electrodes, pads, patterns, structure and/or processes should not be limited by these terms. These terms are only used to distinguish one material, layer, region, pad, electrode, pattern, structure or process from another material, layer, region, pad, electrode, pattern, structure or process. Thus, "first", "second" and/or "third" may be used selectively or interchangeably for each material, layer, region, electrode, pad, pattern, structure or process respectively.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, an expression "at least one of' preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

Hereinafter, two directions among horizontal directions that are substantially parallel to an upper surface of a first substrate or a second substrate, which may be substantially orthogonal to each other, may be referred as first and second directions D1 and D2, respectively, and two directions among the horizontal directions, which may have an acute angle with respect to the first and second directions D1 and D2 and substantially orthogonal to each other, may be referred to as third and fourth directions D3 and D4, respectively. Additionally, a direction substantially perpendicular to the upper surface of the first substrate or the second substrate may be referred to as a vertical direction.

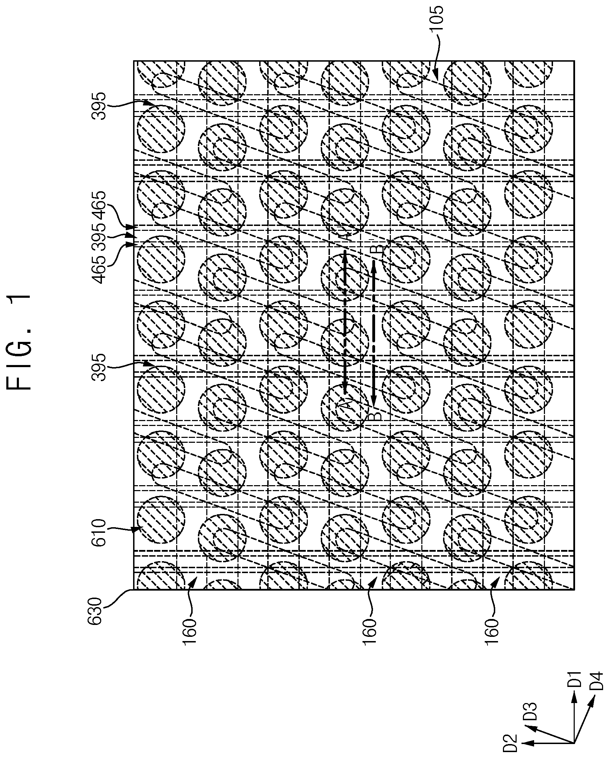

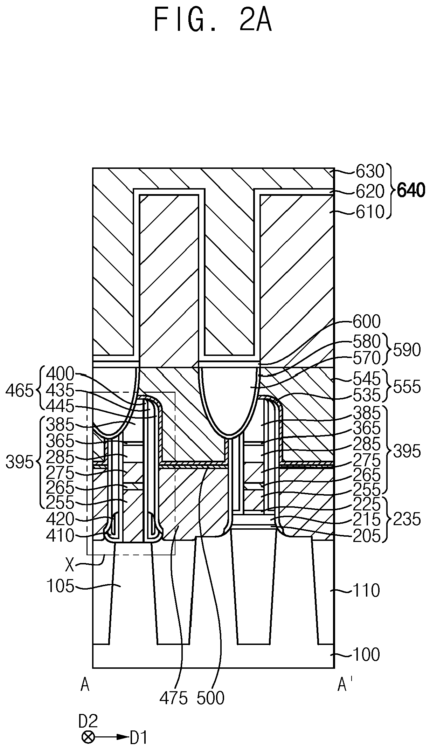

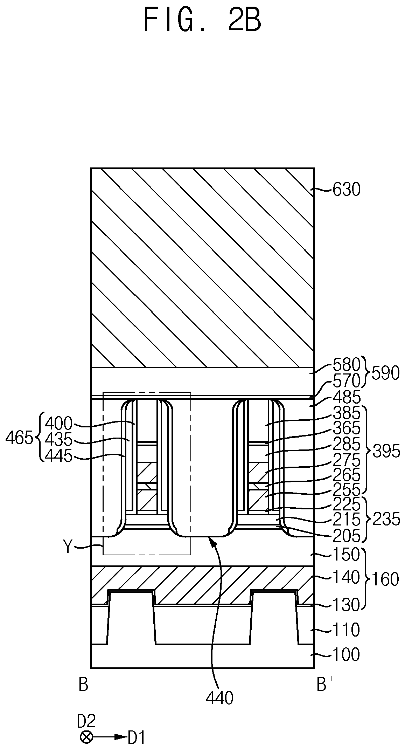

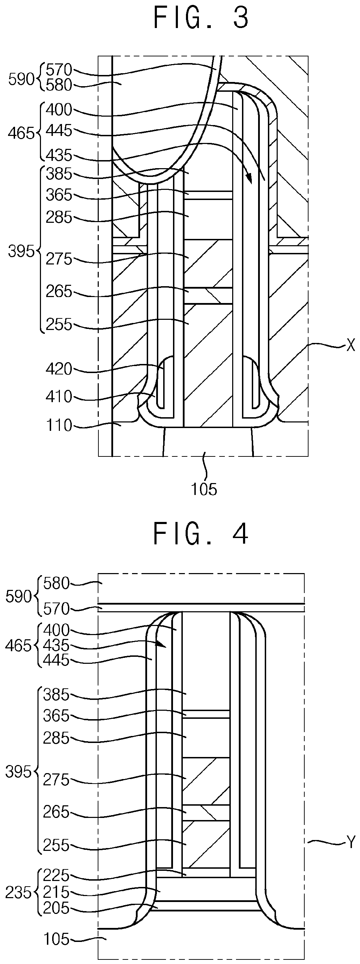

FIG. 1 is a plan view illustrating a semiconductor device, according to embodiments, FIGS. 2A and 2B are cross-sectional views taken along lines A-A' and B-B' of FIG. 1, respectively, and FIGS. 3 and 4 are enlarged cross-sectional views of regions X and Y, respectively, of FIGS. 2A and 2B.

Referring to FIGS. 1 to 4, the semiconductor device includes a first active pattern 105, a first gate structure 160, a first bit line structure 395, a first contact plug structure, and may include a first capacitor 640 on a first substrate 100.

The semiconductor device may further include a first isolation pattern 110, a first spacer structure 460, a first fence pattern 485, first and second insulation pattern structures 235 and 590, fourth and fifth insulation patterns 410 and 420, and a metal silicide pattern 500.

The first substrate 100 may include a semiconductor material, e.g., silicon, germanium, silicon-germanium, etc., or III-V semiconductor compounds, e.g., GaP, GaAs, GaSb, etc. In some embodiments, the first substrate 100 may include a silicon-on-insulator (SOI) substrate or a germanium-on-insulator (GOI) substrate.

The first active pattern 105 may extend in the third direction D3, and a plurality of first active patterns 105 may be spaced apart from each other in the first and second directions D1 and D2. The first isolation pattern 110 may be formed at a sidewall of the first active pattern 105. For example, a sidewall of the first active pattern 105 may be covered by the first isolation pattern 110. The first active pattern 105 may include substantially the same material as the first substrate 100, and the first isolation pattern 110 may include an oxide, e.g., silicon oxide.

In embodiments, an upper surface of a portion of the first active pattern 105 beneath and contacting the first lower contact plug 475 may be at a level higher than a level of an upper surface of a portion of the first isolation pattern 110 beneath and contacting the first lower contact plug 475.

Referring to FIGS. 1 to 4 together with FIG. 6, the first gate structure 160 may be formed in a second recess extending in the first direction D1 through upper portions of the first active pattern 105 and the first isolation pattern 110. The first gate structure 160 may include a first gate insulation pattern 130 on a bottom and a sidewall of the second recess, a first gate electrode 140 on a portion of the first gate insulation pattern 130 on the bottom and a lower sidewall of the second recess, and a gate mask 150 on the first gate electrode 140 and filling an upper portion of the second recess.

The first gate insulation pattern 130 may include an oxide, e.g., silicon oxide, the first gate electrode 140 may include, e.g., a metal, a metal nitride, a metal silicide, etc., and the gate mask 150 may include an insulating nitride, e.g., silicon nitride.

In embodiments, the first gate structure 160 may extend in the first direction D1, and a plurality of first gate structures 160 may be spaced apart from each other in the second direction D2.

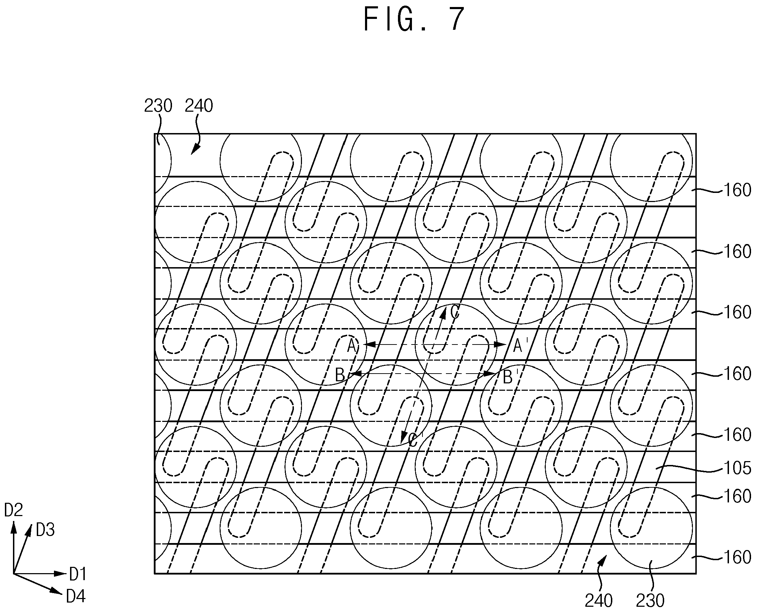

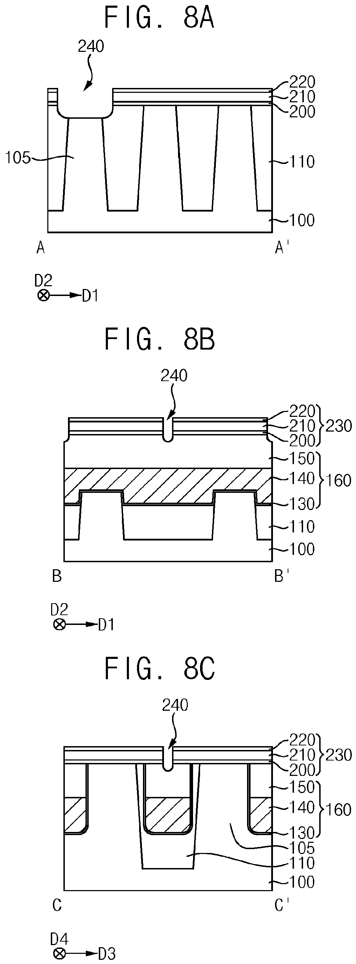

Referring to FIGS. 1 to 4 together with FIGS. 7 and 8, a first opening 240 extending through an insulation layer structure 230 and exposing upper surfaces of the first active pattern 105, the first isolation pattern 110 and the gate mask 150 of the first gate structure 160 may be formed, and an upper surface of a central portion in the third direction D3 of the first active pattern 105 may be exposed by the first opening 240.

In embodiments, an area of a bottom of the first opening 240 may be greater than an area of the upper surface of the first active pattern 105 exposed by the first opening 240. Thus, the first opening 240 may also expose an upper surface of a portion of the first isolation pattern 110 adjacent to the first active pattern 105. Additionally, the first opening 240 may extend through upper portions of the first active pattern 105 and the portion of the first isolation pattern 110 adjacent thereto, and thus the bottom of the first opening 240 may be lower than an upper surface of a portion of the first active pattern 105 on which the first opening 240 is not formed, that is, an upper surface of each of opposite edge portions in the third direction D3 of the first active pattern 105.

The first bit line structure 395 may include a first conductive pattern 255, a first barrier pattern 265, a second conductive pattern 275, a first mask 285, a first etch stop pattern 365 and a first capping pattern 385 sequentially stacked in the vertical direction in the first opening 240 or on the first insulation pattern structure 235. The first conductive pattern 255, the first barrier pattern 265 and the second conductive pattern 275 may collectively form a conductive structure, and the first mask 285, the first etch stop pattern 365 and the first capping pattern 385 may collectively form an insulation structure.

The first conductive pattern 255 may include, e.g., doped polysilicon, the first barrier pattern 265 may include a metal nitride, e.g., titanium nitride, or a metal silicon nitride, e.g., titanium silicon nitride, the second conductive pattern 275 may include a metal, e.g., tungsten, and each of the first mask 285, the first etch stop pattern 365 and the first capping pattern 385 may include an insulating nitride, e.g., silicon nitride.

In embodiments, the first bit line structure 395 may extend in the second direction D2 on the first substrate 100, and a plurality of first bit line structures 395 may be spaced apart from each other in the first direction D1.

The fourth and fifth insulation patterns 410 and 420 may be formed in the first opening 240, and may contact a lower sidewall of the first bit line structure 395. The fourth insulation pattern 410 may include an oxide, e.g., silicon oxide, and the fifth insulation pattern 420 may include an insulating nitride, e.g., silicon nitride.

The first insulation pattern structure 235 may be formed on the first active pattern 105 and the first isolation pattern 110 under the first bit line structure 395, and may include first, second and third insulation patterns 205, 215 and 225 sequentially stacked in the vertical direction. The first and third insulation patterns 205 and 225 may include an oxide, e.g., silicon oxide, and the second insulation pattern 215 may include an insulating nitride, e.g., silicon nitride.

The first contact plug structure may include a first lower contact plug 475, a metal silicide pattern 500 and a first upper contact plug 555 sequentially stacked in the vertical direction on the first active pattern 105 and the first isolation pattern 110.

The first lower contact plug 475 may contact the upper surface of each of opposite edge portions in the third direction D3 of the first active pattern 105. In embodiments, a plurality of first lower contact plugs 475 may be spaced apart from each other between neighboring ones of the first bit line structures 395 in the first direction D1, and a first fence pattern 485 may be formed between neighboring ones of the first lower contact plugs 475 in the second direction D2. The first fence pattern 485 may include an insulating nitride, e.g., silicon nitride.

In embodiments, a width in the first direction D1 of an upper portion of the first fence pattern 485 may not be greater than a width in the first direction D1 of a lower portion of the first fence pattern 485. Instead, a width in the first direction D1 of the first fence pattern 485 may be substantially constant in the vertical direction. The first fence pattern 485 may include an insulating nitride, e.g., silicon nitride.

The first lower contact plug 475 may include, e.g., doped polysilicon, and the metal silicide pattern 500 may include, e.g., titanium silicide, cobalt silicide, nickel silicide, etc.

The first upper contact plug 555 may include a first metal pattern 545 and a second barrier pattern 535 on a lower surface of the first metal pattern 545. The first metal pattern 545 may include a metal, e.g., tungsten, and the second barrier pattern 535 may include a metal nitride, e.g., titanium nitride.

In embodiments, a plurality of first upper contact plugs 555 may be spaced apart from each other in the first and second directions D1 and D2, and may be arranged in a honeycomb pattern or a lattice pattern in a plan view. Each of the first upper contact plugs 555 may have a shape of, e.g., a circle, an ellipse, or a polygon in a plan view.

The first spacer structure 460 may include a first spacer 400 on sidewalls of the first bit line structure 395 and the third insulation pattern 225, a first air spacer 435 on a lower outer sidewall of the first spacer 400 on portions of the fourth and fifth insulation patterns 410 and 420, and a third spacer 445 on an outer sidewall of the first air spacer 435, a sidewall of the first insulation pattern structure 235, and upper surfaces of portions of the fourth and fifth insulation patterns 410 and 420. The first spacer 400 may cover the sidewalls of the first bit line structure 395 and the third insulation pattern 225.

In embodiments, an outer sidewall of an end portion in the vertical direction of the third spacer 445 may include a vertex (or a sharp point) at which a slope may abruptly change.

In embodiments, in the cross-section in the first direction D1 of the third spacer 445, the outer sidewall of the end portion in the vertical direction of the third spacer 445 may include two curves that meet each other at the vertex.

In an embodiment, the slope of the end portion in the vertical direction of the outer sidewall of the third spacer 445, as it moves away from the upper surface of the first substrate 100 in the vertical direction, may have a positive value which may gradually increase, reach 90 degrees, and then have a negative value. At the vertex, the slope may change non-linearly and abruptly to have a positive value again, and then the slope may increase continuously as it moves away from the vertex in the vertical direction away from the upper surface of the first substrate 100.

In another embodiment, the slope of the end portion in the vertical direction of the outer sidewall of the third spacer 445, as it moves away from the upper surface of the first substrate 100 in the vertical direction, may have a positive value which may gradually increase, change non-linearly and abruptly at the vertex to have a much reduced positive value than that of a portion of the outer sidewall of the third spacer 445 adjacent to the vertex, and then continuously increase.

In embodiments, the third spacer 445 may directly contact the first lower contact plug 475 and the first fence pattern 485.

Each of the first and third spacers 400 and 445 may include an insulating nitride, e.g., silicon nitride, and the first air spacer 435 may include air.

FIGS. 2A-2B and 3 shows that the first spacer structure 460 has a triple layer structure having the first and third spacers 400 and 445 and the first air spacer 435, however, the disclosure may not be limited to, and may have a single layer structure or a double layer structure.

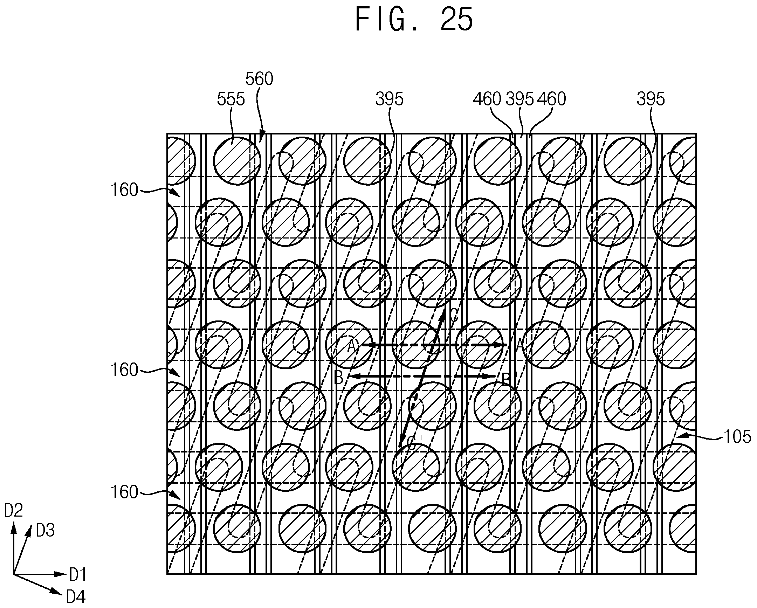

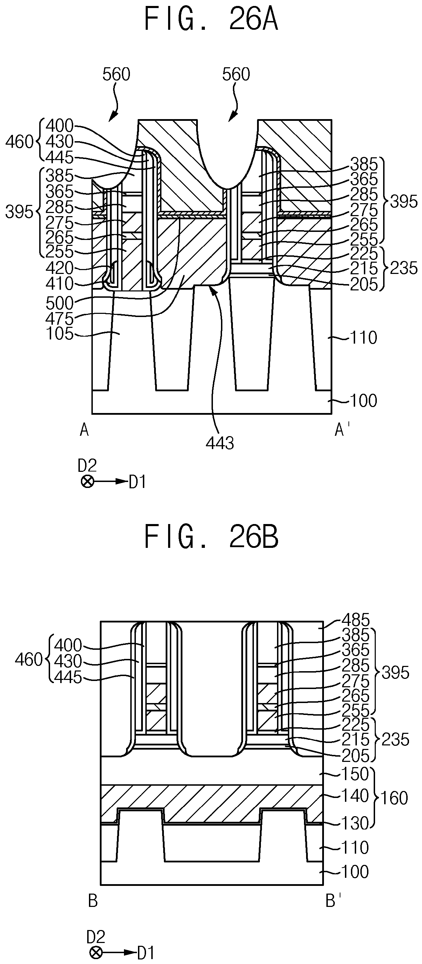

Referring to FIGS. 1 to 4 together with FIGS. 25 and 26, the second insulation pattern structure 590 may include a sixth insulation pattern 570 on an inner wall of a sixth opening 560, which may extend through the first upper contact plug 555, a portion of the insulation structure of the first bit line structure 395 and portions of the first and third spacers 400 and 445 and surround the first upper contact plug 555 in a plan view. Further, the second insulating pattern structure 590 may include an seventh insulation pattern 580, on the sixth insulation pattern 570, filling a remaining portion of the sixth opening 560. The upper end of the first air spacer 435 may be closed by the sixth insulation pattern 570.

The sixth and seventh insulation patterns 570 and 580 may include an insulating nitride, e.g., silicon nitride.

As described below, in a method of manufacturing the semiconductor device, the width of the first fence pattern 485 between the first lower contact plugs 475 may be substantially constant, instead of having a width gradually increasing from a bottom to a top thereof in the vertical direction. Accordingly, the first fence pattern 475 need not tilt to one side or collapse.

In addition, in the method of manufacturing the semiconductor device, the first contact plug 475 contacting each of opposite edge portions of the first active pattern 105 need not contact adjacent conductive structures, and accordingly, electrical short between the first lower contact plug 475 and the adjacent conductive structures may be reduced or prevented.

FIGS. 5 to 27A-27B are plan views and cross-sectional views illustrating a method of manufacturing a semiconductor device according to embodiments. Specifically, FIGS. 5, 7, 10, 21 and 25 are the plan views, and FIGS. 6A-6C, 8A-8C, 9A-9C, 11A-11C, 12A-12C, 13A-13C, 16A-16C, 17A-17C, 19A-19C and 22A-22C are cross-sectional views taken along lines A-A', B-B' and C-C' of corresponding plan views, respectively. FIGS. 23A-23B, 24A-24B, 26A-26B and 27A-27B are cross-sectional views taken along lines A-A' and B-B' of corresponding plan views, respectively. FIGS. 14 and 20 are enlarged cross-sectional views of region X of corresponding plan views, respectively, and FIGS. 15 and 18 are enlarged cross-sectional views of region Y of corresponding plan views, respectively.

Referring to FIGS. 5 and 6A-6C, an upper portion of a first substrate 100 may be removed to form a first recess in which a first isolation pattern may be formed, and a first active pattern 105 may be defined on the first substrate 100.

The first isolation pattern 110 may be formed, in the first recess, on a sidewall of the first active pattern 105. The sidewall of the first active pattern 105 may be covered by the first isolation pattern 110.

The first active pattern 105 and the first isolation pattern 110 on the first substrate 100 may be partially etched to form a second recess extending in the first direction D1, and a first gate structure 160 may be formed in the second recess. In embodiments, the first gate structure 160 may extend in the first direction D1, and a plurality of first gate structures may be spaced apart from each other in the second direction D2.

Referring to FIGS. 7 and 8A-8C, an insulating layer structure 230 may be formed on the first active pattern 105, the first isolation pattern 110, and the first gate structure 160. The insulating layer structure 230 may include first to third insulating layers 200, 210, and 220 sequentially stacked.

The insulating layer structure 230 may be patterned, and the first active pattern 105, the first isolation pattern 110, and the gate mask 150 included in the first gate structure 160 may be partially etched using the patterned insulating layer structure 230 as an etching mask to form a first opening 240. In embodiments, the insulating layer structure 230 may have a circular shape or an elliptical shape in a plain view, and a plurality of insulating layer structures 230 may be spaced apart from each other in the first and second direction D1 and D2. Each of the insulating layer structures 230 may overlap opposite end portions of ones of the first active patterns 105 neighboring in the first direction D1 and the third direction D3, which may face each other, in a vertical direction substantially orthogonal to the upper surface of the first substrate 100.

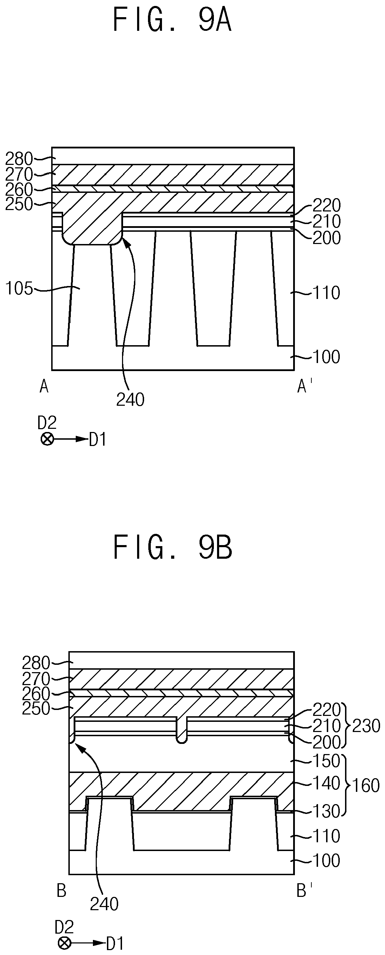

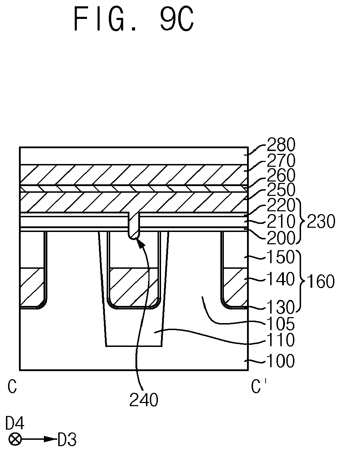

Referring to FIGS. 9A-9C, a first conductive layer 250, a first barrier layer 260, a second conductive layer 270 and a first mask layer 280 may be sequentially stacked on the insulating layer structure 230, and the first active pattern 105, the first isolation pattern 110 and the first gate structure 160 exposed by the first opening 240. The first conductive layer 250 may fill the first opening 240.

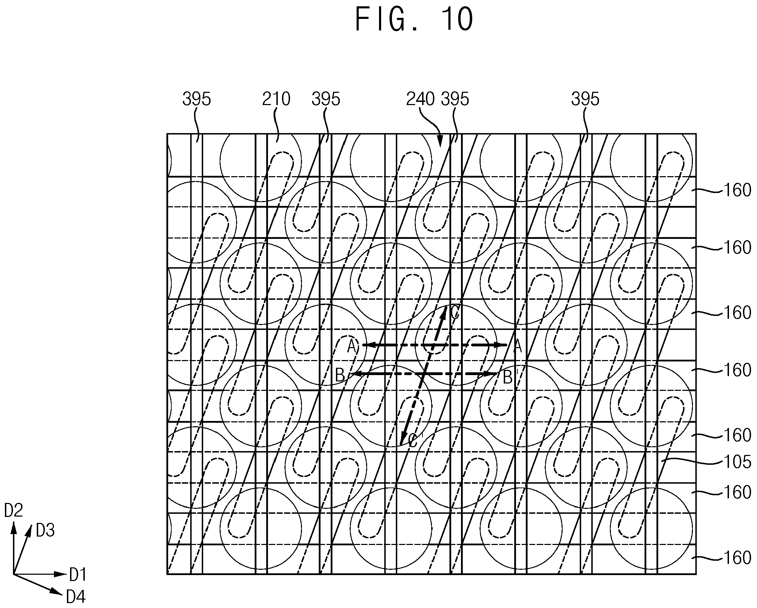

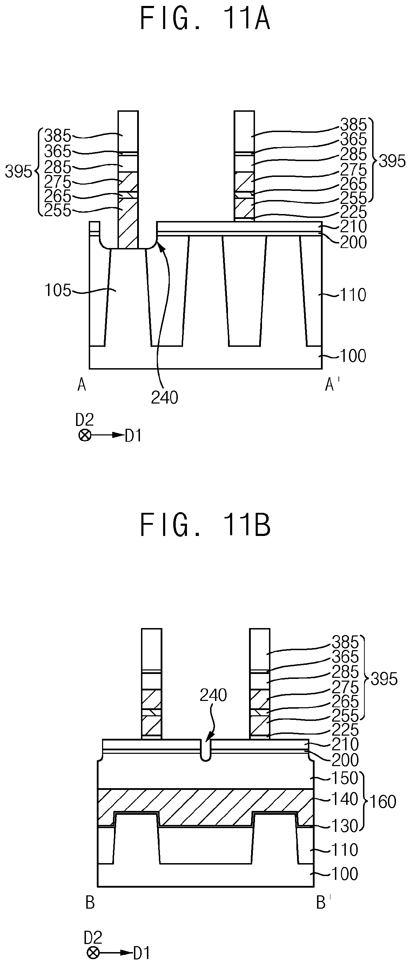

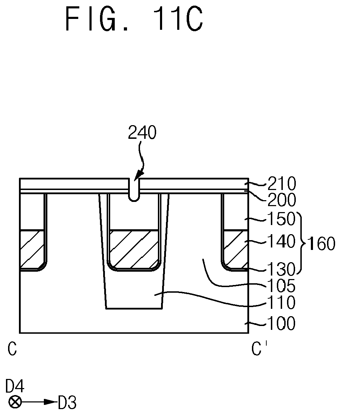

Referring to FIGS. 10 and 11A-11C, a first etch stop layer and a first capping layer may be sequentially formed on the first mask layer 280, the first capping layer may be etched to form a first capping pattern 385, and the first etch stop layer, the first mask layer 280, the second conductive layer 270, the first barrier layer 260 and the first conductive layer 250 may be sequentially etched using the first capping pattern 385 as an etch mask.

In embodiments, the first capping pattern 385 may extend in the second direction D2, and a plurality of first capping patterns 385 may be spaced apart from each other in the first direction D1.

By the etching process, a first conductive pattern 255, a first barrier pattern 265, a second conductive pattern 275, a first mask 285, a first etch stop pattern 365 and the first capping pattern 385 may be sequentially stacked on the first opening 240, and a third insulation pattern 225, the first conductive pattern 255, the first barrier pattern 265, the second conductive pattern 275, the first mask 285, the first etch stop pattern 365 and the first capping pattern 385 may be sequentially stacked on the second insulating layer 210 of the insulating layer structure 230 at an outside of the first opening 240.

Hereinafter, the first conductive pattern 255, the first barrier pattern 265, the second conductive pattern 275, the first mask 285, the first etch stop pattern 365 and the first capping pattern 385 sequentially stacked may be referred to as a first bit line structure 395. The first conductive pattern 255, the first barrier pattern 265 and the second conductive pattern 275 may form a conductive structure, and the first mask 285, the first etch stop pattern 365 and the first capping pattern 385 may form an insulation structure. In embodiments, the first bit line structure 395 may extend in the second direction D2, and a plurality of first bit line structures 395 may be spaced apart from each other in the first direction D1.

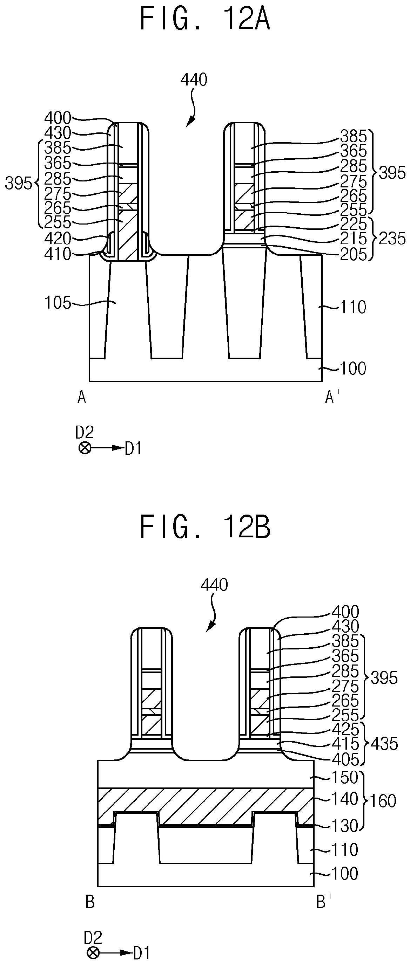

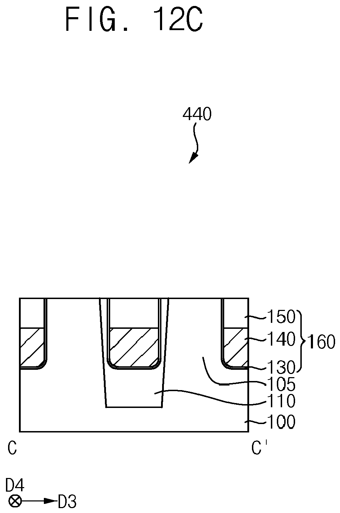

Referring to FIGS. 12A-12C, a first spacer layer may be formed on the first substrate 100 on which the first bit line structure 395 is formed, and fourth and fifth insulating layers may be sequentially formed on the first spacer layer.

The first spacer layer may also be formed on a sidewall of the third insulation pattern 225 under the first bit line structure 395 on the second insulating layer 210, and the fifth insulating layer may fill a remaining portion of the first opening 240.

The fourth and fifth insulating layers may be etched by an etching process. In embodiments, the etching process may be performed by a wet etching process using, for example, phosphoric acid (H₂PO₃), SC1, and hydrofluoric acid (HF) as an etchant, and portions of the fourth and fifth insulating layers except for portions thereof in the first opening 240 may be removed. Accordingly, most portion of a surface of the first spacer layer, that is, all portions of the surface of the first spacer layer except for a portion of the surface thereof in the first opening 240 may be exposed, and the fourth and fifth insulating layers remaining in the first opening 240 may form fourth and fifth insulation patterns 410 and 420, respectively.

A second spacer layer may be formed on the exposed surface of the first spacer layer and the fourth and fifth insulation patterns 410 and 420 in the first opening 240. The second spacer layer may be anisotropically etched to form a second spacer 430 on a sidewall of the first bit line structure 395 on the surface of the first spacer layer and on the fourth and fifth insulation patterns 410 and 420.

A dry etching process may be performed using the first capping pattern 385 and the second spacer 430 as an etch mask to form a second opening 440 exposing an upper surface of the first active pattern 105, and upper surfaces of the first isolation pattern 110 the gate mask 150 may also be exposed by the second opening 440.

By the dry etching process, portions of the first spacer layer on upper surfaces of the first capping pattern 385 and the second insulating layer 210 may be removed, and thus a first spacer 400 may be formed on the sidewall of the first bit line structure 395. By the dry etching process, the first and second insulating layers 200 and 210 may be partially removed to remain as first and second insulation patterns 205 and 215, respectively, under the first bit line structure 395. The first to third insulation patterns 205, 215 and 225 sequentially stacked under the first bit line structure 395 may form a first insulation pattern structure 235.

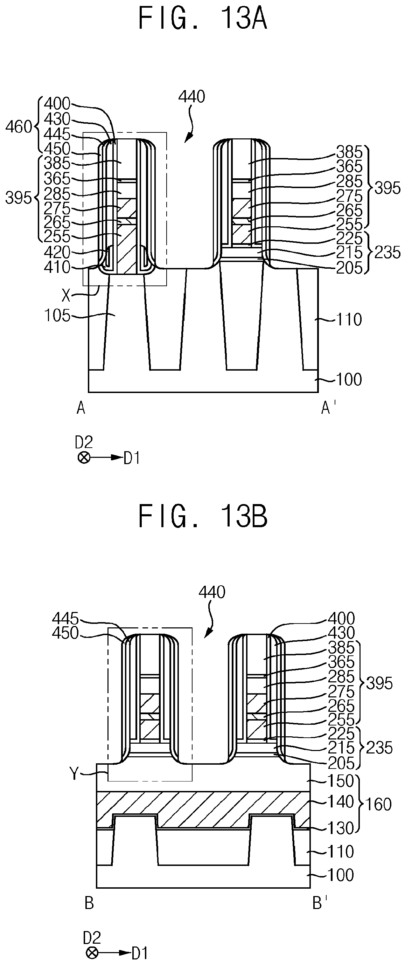

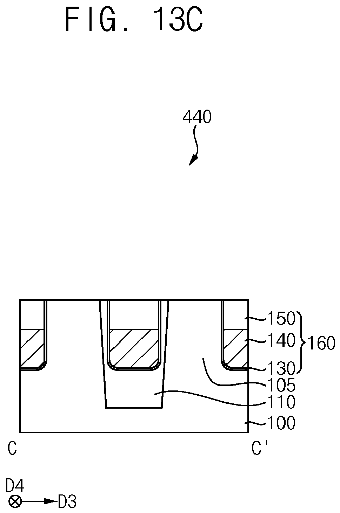

Referring to FIGS. 13A-13C to 15, a third spacer layer and a first protective spacer layer may be formed on an upper surface of the first capping pattern 385, an outer sidewall of the second spacer 430, portions of the upper surfaces of the fourth and fifth insulation patterns 410 and 420, and upper surfaces of the first active pattern 105, the first isolation pattern 110 and the gate mask 150 exposed by the second opening 440.

The third spacer layer and the first protective spacer layer may be anisotropically etched to form a third spacer 445 and a protective spacer 450 on the sidewall of the first bit line structure 395. The second opening 440 exposing the upper surface of the first active pattern 105 may be formed again.

In embodiments, the first protective spacer 450 may include a material having a high etching selectivity with respect to a first sacrificial layer that may formed subsequently. That is, the first protective spacer 450 may include, e.g., a metal nitride such as titanium nitride (TiN), or a low dielectric material such as silicon oxycarbide (SiOC), silicon oxycarbonitride (SiOCN), etc.

The first to third spacers 400, 430 and 445 sequentially stacked on the sidewall of the first bit line structure 395 in the horizontal direction may be referred to as a first preliminary spacer structure 460.

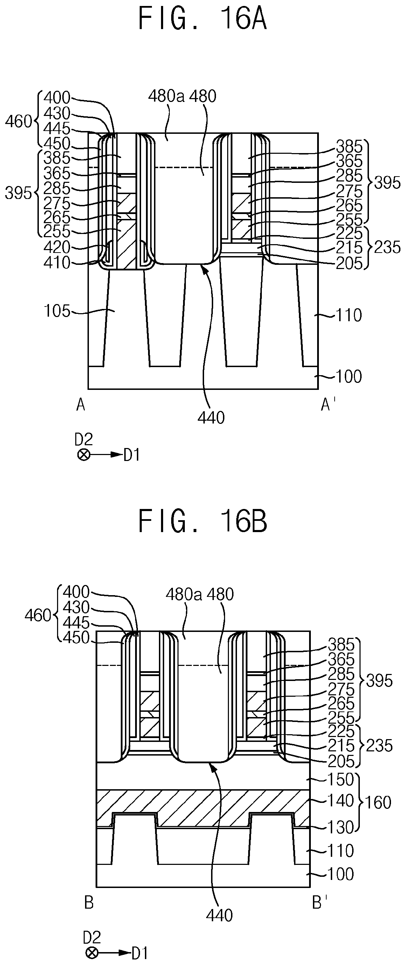

Referring to FIGS. 16A-16C, a first sacrificial layer may be formed to fill the second opening 440 on the first substrate 100 to a sufficient height, and an upper portion of the second sacrificial layer may be planarized until the upper surface of the first capping pattern 385 is exposed to form a first sacrificial pattern 480 in the second opening 440.

In embodiments, the first sacrificial pattern 480 may extend in the second direction D2, and a plurality of first sacrificial patterns 480 may be spaced apart from each other in the first direction D1 by the first bit line structures 395. The first sacrificial pattern 480 may include, for example, an oxide such as silicon oxide.

An ion implantation process may be performed on the first sacrificial pattern 480 so that an upper portion of the first sacrificial pattern 480 may be doped with ions, e.g., helium (He) ions. Accordingly, an ion-containing region 480a which may be relatively resistant to etching processes may be formed at the upper portion of the first sacrificial pattern 480.

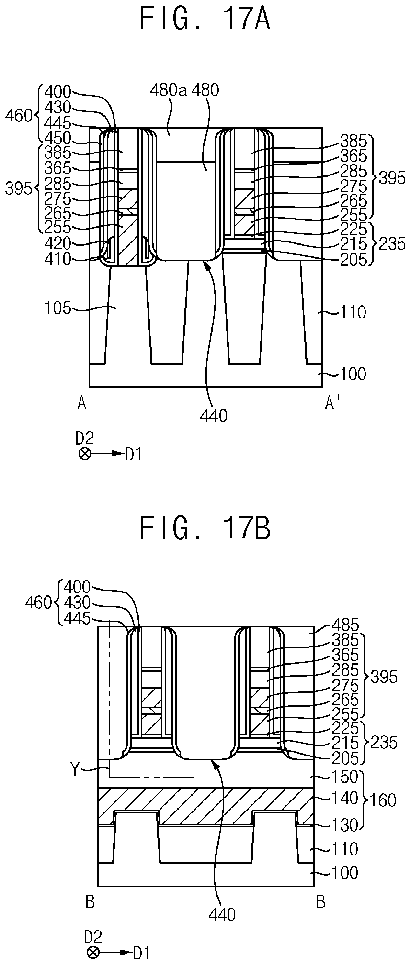

Referring to FIGS. 17A-17C and 18, a second mask including a plurality of third openings, each of which may extend in the first direction D1, spaced apart from each other in the second direction D2, may be formed on the first capping pattern 385, the first sacrificial pattern 480 and the first preliminary spacer structure 460, and may be etched using the second mask as an etching mask.

The third openings may overlap the first gate structures 160, respectively, in the vertical direction. By the etching process, a fourth opening exposing the first protective spacer 450 and an upper surface of the gate structure 160 may be formed between the first bit line structures 395 on the first substrate 100.

The ion-containing region 480a doped with helium (He) may be formed at the upper portion of the first sacrificial pattern 480 so that the upper portion of the first sacrificial pattern 480 may not be over-etched during the etching process for forming the fourth opening. Accordingly, a bowing phenomenon in which a width of an upper portion of the fourth opening in the first direction D1 is excessively increased may be prevented.

In addition, the first protective spacer 450 on the third spacer 445 may include a material with a high etching selectivity with respect to the first sacrificial pattern 480, and thus the third spacer 445 may not be removed during the etching process. Accordingly, the third spacer 445 may not have a thick thickness in case that the third spacer 445 may be partially removed.

After the second mask is removed, a portion of the first protective spacer 450 exposed by the fourth opening may be removed by, for example, a wet etching process so that a width in the first direction D1 of the fourth opening may be enlarged. However, in some embodiments, the portion of the first protective spacer 450 exposed by the fourth opening may not be removed.

A first fence layer may be formed to fill the fourth opening to a sufficient height, and an upper portion of the first fence layer may be planarized until the upper surface of the first capping pattern 385, the first sacrificial pattern 480 and the first preliminary spacer structure 460 are exposed. Thus, the first fence layer may be transformed into a plurality of first fence patterns 485 spaced apart from each other in the second direction D2 between the first bit line structures 395.

As described above, if the portion of the first protective spacer 450 exposed by the fourth opening is removed, the width in the first direction D1 of the fourth opening may be enlarged, and thus, the process of forming the first fence layer in the fourth opening may be performed more easily.

Also, as described above, the ion-containing portion 480a may be formed at the upper portion of the first sacrificial pattern 480, and accordingly, while the fourth opening is formed, the bowing phenomenon may not occur at the upper portion of the fourth opening. Thus, the upper portion of the first sacrificial pattern 480 may not have a large thickness, so that the width in the first direction D1 of the upper portion of the first sacrificial pattern 480 need not be greater than the width in the first direction D1 of the lower portion of the first sacrificial pattern 480. Rather, the width in the first direction D1 of the first sacrificial pattern 280 may be substantially constant in the vertical direction, and thus the first fence pattern 485 need not tilt to one side or collapse.

In embodiments, the first fence pattern 485 may overlap the first gate structure 160 in the vertical direction.

In embodiments, each of the first sacrificial patterns 480 extending in the second direction D2 between the first bit line structures 395 may be spaced apart from each other in the second direction D2 by the first fence patterns 485.

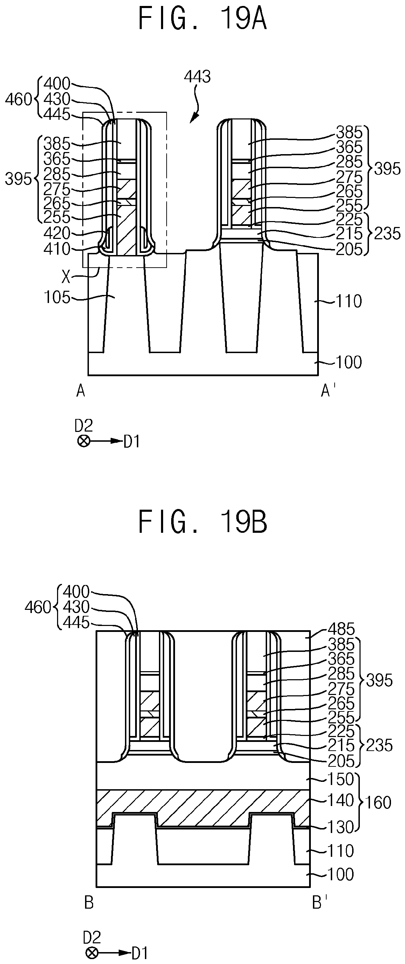

Referring to FIGS. 19A-19C and 20, the first sacrificial pattern 480 may be removed to form a fifth opening 443 exposing the first active pattern 105, the first isolation pattern 110, and the first protective spacer 450.

The portion of the protective spacer 450 exposed by the fifth opening 443 may be removed by, for example, a wet etching process, and accordingly, a width in the first direction D1 of the fifth opening 443 may be enlarged in the first direction D1. The wet etching process may be performed by using an etchant with a high etching selectivity with respect to silicon (Si) included in the first active pattern 105.

However, in some embodiments, the portion of the protective spacer 450 exposed by the fifth opening 443 may not be removed.

In embodiments, the first isolation pattern 110 exposed by the fifth opening 443 may be partially removed by an additional wet etching process, and accordingly, an area of an upper surface of the first active pattern 105 exposed by the fifth opening 443 may increase. By the additional wet etching process, the fifth opening 443 may also be enlarged in the vertical direction, and thus, the upper surface of the first active pattern 105 exposed by the fifth opening 443 may be at a higher level than an upper surface of the first isolation pattern 110 exposed by the fifth opening 443.

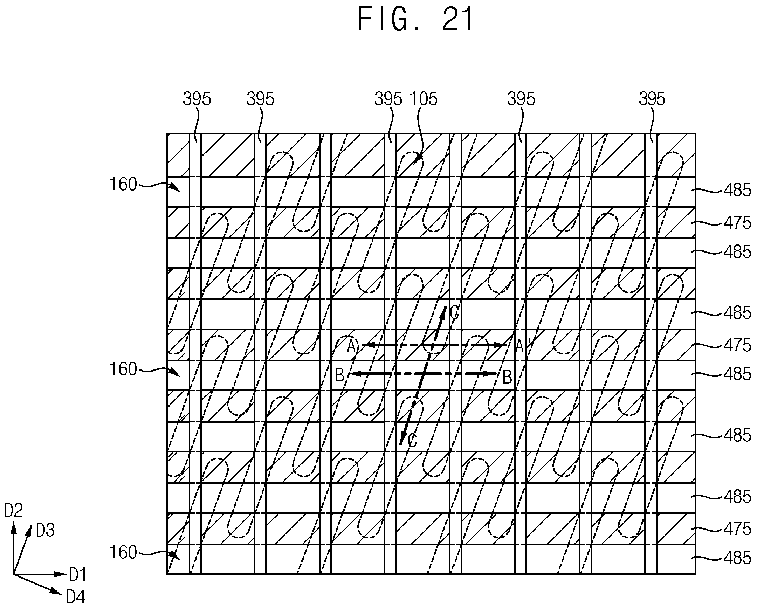

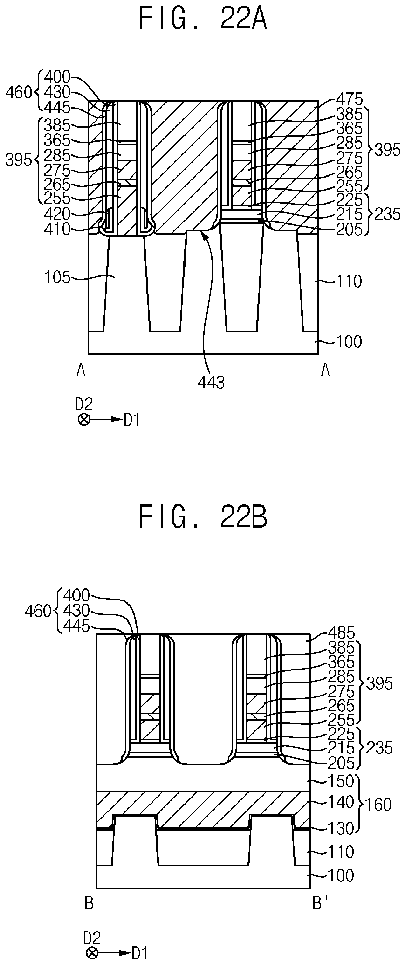

Referring to FIGS. 21 and 22A-22C, a first lower contact plug 475 may be formed to fill the fifth opening 443.

As described above, if the portion of the first protective spacer 450 exposed by the fifth opening 443 is removed, the width in the first direction D1 of the fifth opening 443 can be enlarged, and thus, voids may not be form in the first lower contact plug 475.

In an embodiment, the first lower contact plug 475 may be formed by an epitaxial growth process using the first active pattern 105 exposed by fifth opening 443 as a seed. In the epitaxial growth process, the first lower contact plug 475 may be grown upwardly in the vertical direction, so that void may not be formed in the first lower contact plug 475 or may have a very small volume.

The first lower contact plug 475 may be planarized until the upper surface of the first capping pattern 385 is exposed. The planarization process may include a chemical mechanical polishing (CMP) process and/or an etch back process.

In another embodiment, a first lower contact plug layer may be formed to fill the fifth opening 443 by a deposition process such as a chemical vapor deposition (CVD) process, an atomic layer deposition (ALD) process, etc., and an upper portion of the first lower contact plug layer may be planarized until the upper surface of the first capping pattern 385 is exposed to form the first lower contact plug 475.

In still another embodiment, a lower portion of the first lower contact plug 475 may be formed by the epitaxial growth process, and an upper portion of the first lower contact plug 475 may be formed by the deposition process and the planarization process.

In embodiments, a heat treatment process, for example, a melting laser annealing (MLA) process may be additionally performed on the first lower contact plug 475 to remove voids therein.

Referring to FIGS. 23A and 23B, an upper portion of the first lower contact plug 475 may be removed. Accordingly, an upper surface of the first lower contact plug 475 may be lower than uppermost surfaces of the first to third spacers 400, 430 and 445.

A metal silicide pattern 500 may be formed on the upper surface of the first lower contact plug 475. In embodiments, the metal silicide pattern 500 may be formed by forming a first metal layer on the first capping pattern 385, the first fence pattern 485 and the first lower contact plug 475, performing a heat treatment thereon, and removing an unreacted portion of the first metal layer.

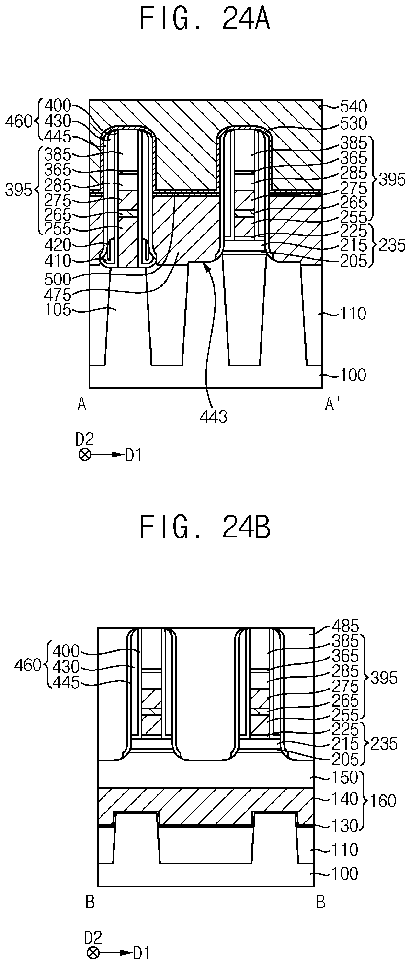

Referring to FIGS. 24A and 24B, a second barrier layer 530 may be formed on the first capping pattern 385, the first fence pattern 485, the metal silicide pattern 500 and the first lower contact plug 475, and a second metal layer 540 may be formed on the second barrier layer 530 to fill a space between the first bit line structures 395.

A planarization process may be additionally performed on an upper portion of the second metal layer 540. The planarization process may include, for example, a chemical mechanical polishing (CMP) process and/or an etch-back process.

Referring to FIGS. 25 to 27A-27B, the second metal layer 540 and the second barrier layer 530 may be patterned to form a first upper contact plug 555. In embodiments, a plurality of first upper contact plugs 555 may be formed, and a sixth opening 560 may be formed between the upper contact plugs 555.

The sixth opening 560 may be formed by partially removing the first capping pattern 385, the first fence pattern 485 and the first preliminary spacer structure 460 as well as the second metal layer 540 and the second barrier layer 530.

The first upper contact plug 555 may include a first metal pattern 545 and a second barrier pattern 535 on a lower surface of the first metal pattern 545. In embodiments, the first upper contact plug 555 may have a shape of a circle, an ellipse, or a rounded polygon in a plan view, and the first upper contact plugs 555 may be arranged, for example, in a honeycomb pattern in the first and second direction D1 and D2, in a plan view.

The first lower contact plug 475, the metal silicide pattern 500 and the first upper contact plug 555 sequentially stacked on the first substrate 100 may collectively form a first contact plug structure.

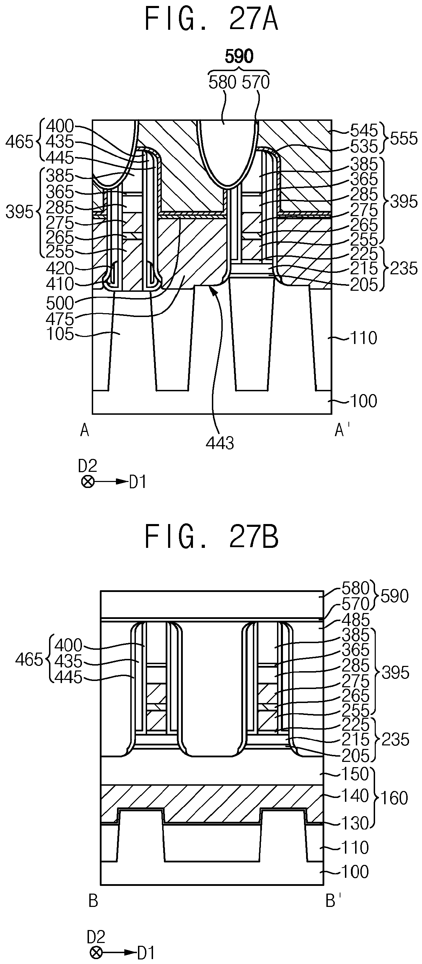

Referring to FIGS. 27A-27B, the second spacer 430 included in the first preliminary spacer structure 460 exposed by the sixth opening 560 may be removed to form an air gap, a sixth insulation pattern 570 may be formed on a bottom and a sidewall of the sixth opening 560, and a seventh insulation pattern 580 may be formed to fill a remaining portion of the sixth opening 560.

Each of the sixth and seventh insulation patterns 570 and 580 may form a second insulation pattern structure 590.

An upper end of the air gap have the sixth insulation pattern 570 thereon, and thus a first air spacer 435 may be formed. The first spacer 400, the first air spacer 435 and the third spacer 445 may form a first spacer structure 460.

Referring back to FIGS. 1 to 4, a first capacitor 640 may be formed to contact an upper surface of the first upper contact plug 555.

That is, a second etch stop pattern 600 and a mold layer may be sequentially stacked on the first upper contact plug 555 and the second insulation pattern structure 590, and the second etch stop pattern 600 and the mold layer may be partially etched to form a seventh opening partially exposing the upper surface of the first upper contact plug 555.

A plurality of seventh openings exposing the upper surfaces of the first upper contact plugs 555, respectively, may be arranged in a honeycomb pattern or a lattice pattern in a plan view.

A first lower electrode 610 having, for example, a shape of a pillar, may be formed to fill the seventh opening, the mold layer may be removed, and a first dielectric layer 620 and a first upper electrode 630 may be formed on the first lower electrode 610 and the second etch stop pattern 600. The first lower electrode 610, the first dielectric 620 and the first upper electrode 630 may collectively form the first capacitor 640.

In some embodiments, the first lower electrode 610 may have a shape of cylinder.

Upper wirings may be further formed to complete the fabrication of the semiconductor device.

In the method of manufacturing the semiconductor device, the first preliminary spacer structure 460 and the first protective spacer 450 may be formed on the sidewall of the first bit line structure 395, the first sacrificial pattern 480 may be formed between the first bit line structures 395, the first sacrificial pattern 480 may be partially removed to form the fourth opening, and the first fence pattern 485 may be formed to fill the fourth opening. Also, the remaining portion of the first sacrificial pattern 480 may be removed to form the fifth opening, and the first lower contact plug 475 may be formed to fill the fifth opening.

The first protective spacer 450 may include a material having a high etching selectivity with respect to that of the first sacrificial pattern 480, and accordingly, during the etching process for forming the fourth and fifth openings, the first protective spacer 450 may protect the first preliminary spacer structure 460 so as to not be removed. Thus, the first preliminary spacer structure 460 may not be formed to be excessively thick in case that the first preliminary spacer structure 460 is removed during the etching process.

Also, the first protective spacer 450 may be removed by, for example, a wet etching process, after the fourth and fifth openings are formed, and widths of the fourth and fifth openings may increase. Accordingly, the processes of forming the first fence pattern 485 and the first lower contact plug 475 in the fourth and fifth openings, respectively, may be performed easily.

In a comparative embodiment, instead of forming the first sacrificial pattern 480, the first lower contact plug 475 and the first fence pattern 485 are formed by following processes. For example, the first lower contact plug 475 is formed between the first bit line structures 395, the first lower contact plugs 475 is partially removed to form an opening, and the first fence pattern 485 is formed in the opening. In this case, the first lower contact plug 475 may not be removed sufficiently, and thus an electrical short may occur between the first lower contact plug 475 and adjacent conductive structures. However, in embodiments, the first sacrificial pattern 480 including an insulating material may be partially removed to form the fourth and fifth openings, and the first lower contact plug 475 may be formed in the fifth opening. Thus, even if the first sacrificial pattern 480 is insufficiently removed, an electrical short between the first lower contact plug 475 and the adjacent conductive structures may not occur.

In addition, the upper portion of the first sacrificial pattern 480 may be strengthened against the etching process by forming the ion-containing portion 480a through an ion implantation process, and accordingly, the bowing phenomenon, in which the width of the upper portion of the fourth opening is enlarged when compared to the width of the lower portion thereof, may be prevented. Thus, the first fence pattern 485 in the fourth opening may not tilt to one side or collapse.

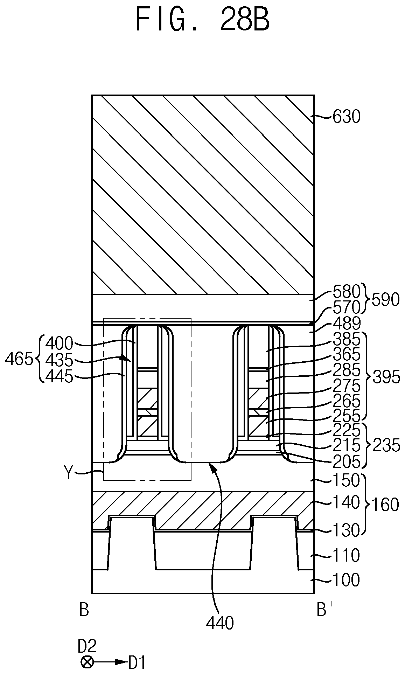

FIGS. 28A and 28B are cross-sectional views illustrating a semiconductor device, according to embodiments. This semiconductor device may be substantially the same as or similar to that of FIGS. 1 to 4, except for some elements, and thus repeated explanations are omitted herein.

Referring to FIG. 28, a fourth spacer 490 may be additionally formed.

The fourth spacer 490 may be formed on an outer sidewall of a portion of the first spacer 400 on an upper sidewall of the first bit line structure 395, and may be formed on the upper end of the first air spacer 435 and the upper surface of the third spacer 445. The fourth spacer 490 may include an insulating nitride, e.g., such as silicon nitride.

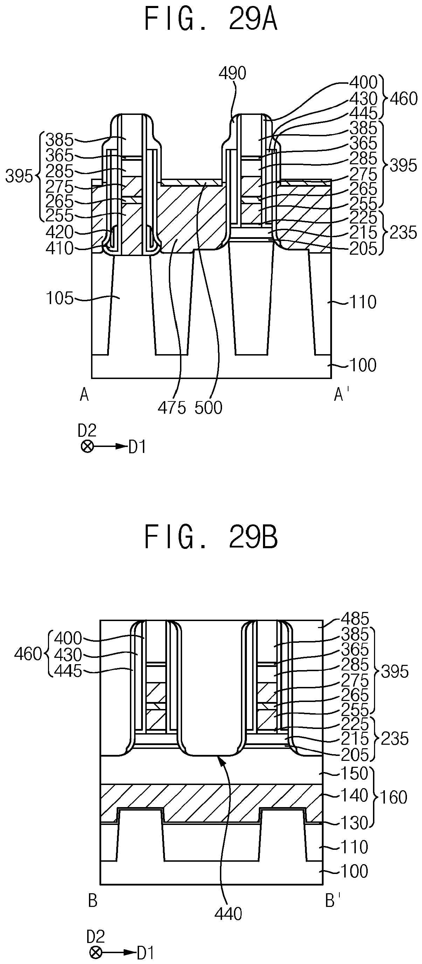

FIG. 29 is a cross-sectional view illustrating a method of manufacturing a semiconductor device, according to embodiments. This method may include processes substantially the same as or similar to those illustrated with reference to FIGS. 5 to 27 and FIGS. 1 to 4, and thus repeated explanations are omitted herein.

Referring to FIG. 29, processes substantially the same as or similar to those illustrated with reference to FIG. 23 may be performed.

However, after removing an upper portion of the first lower contact plug 475 to expose an upper portion of the first preliminary spacer structure 460 on the sidewall of the first bit line structure 395, upper portions of the second and third spacers 430 and 445 of the exposed first preliminary spacer structure 460 may be removed.

An upper portion of the first lower contact plug 475 may be additionally removed. Thus, an upper surface of the first lower contact plug 475 may be at a level lower than those of upper surfaces of the second and third spacers 430 and 445.

A fourth spacer layer may be formed on the first bit line structure 395, the first preliminary spacer structure 460, the first fence pattern 485 and the first lower contact plug 475, and may be anisotropically etched to form a fourth spacer 490 on an upper portion of the first preliminary spacer structure 460 on the sidewall of the first bit line structure 395. Thus, the upper surface of the first lower contact plug 475 may be exposed by the etching process.

A metal silicide pattern 500 may be formed on the exposed upper surface of the first lower contact plug 475

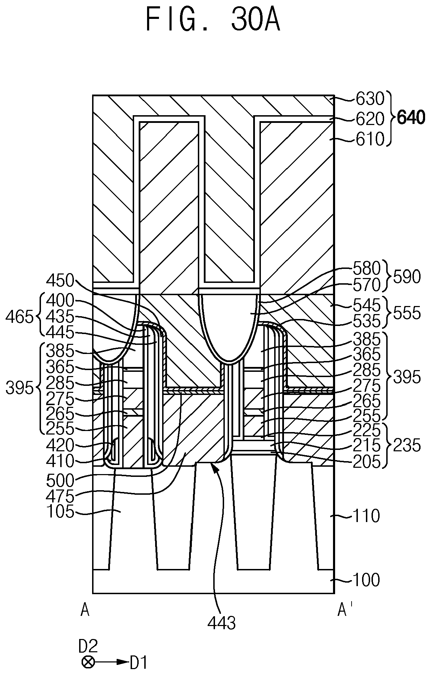

FIGS. 30A-30B to 32A-32B are cross-sectional views illustrating semiconductor devices, according to embodiments. These semiconductor devices may be substantially the same as or similar to that of FIGS. 1 to 4, except for some elements, and thus repeated explanations are omitted herein.

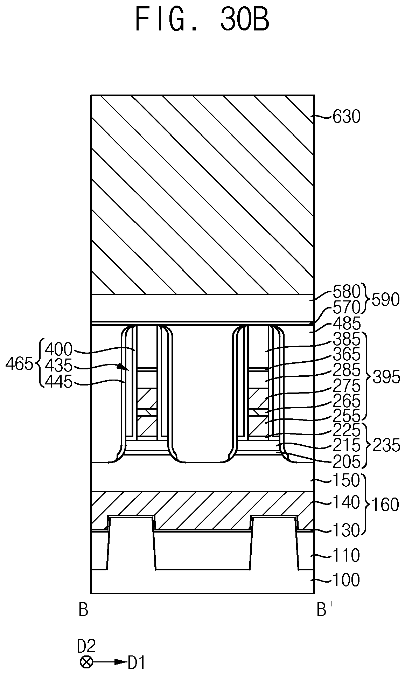

Referring to FIGS. 30A and 30B, the first protective spacer 450 may be additionally formed on an outer sidewall of the third spacer 445, and the first protective spacer 450 may contact the first lower contact plug 475.

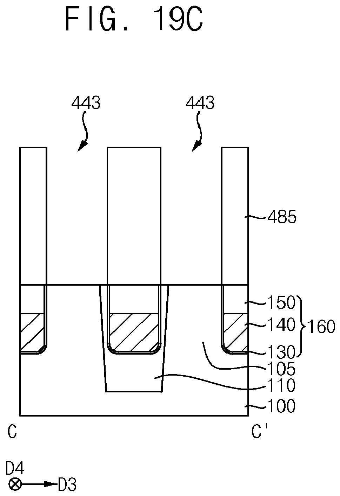

The first protective spacer 450 in FIG. 30 may be implemented by not removing a portion of the first protective spacer 450 exposed by the fifth opening 443 when the processes illustrated with reference to FIGS. 19 and 20 are performed.

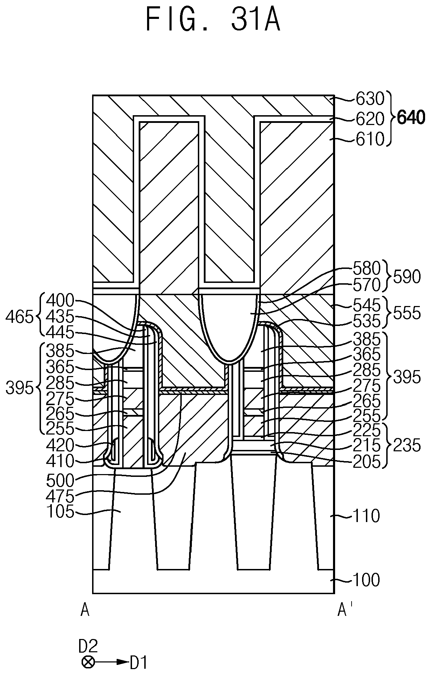

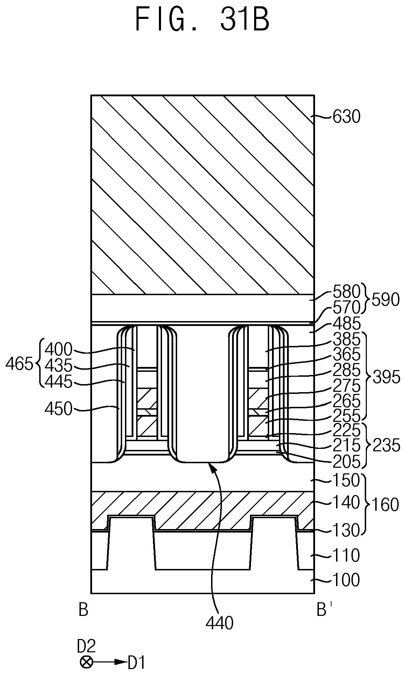

Referring to FIGS. 31A and 31B, the first protective spacer 450 may be additionally formed on an outer sidewall of the third spacer 445, and the first protective spacer 450 may contact the first fence pattern 485.

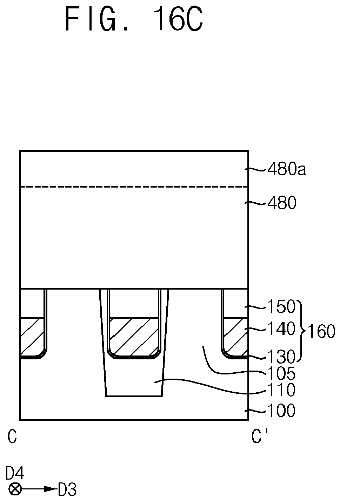

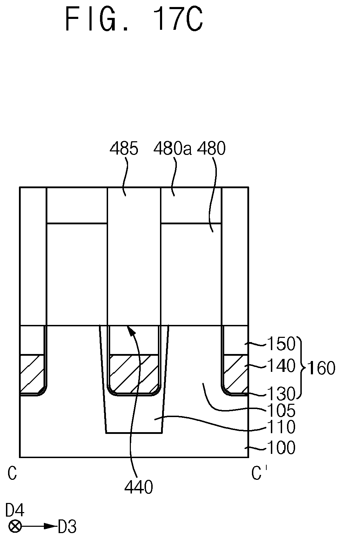

The first protective spacer 450 in FIGS. 31A and 31B may be implemented by not removing a portion of the first protective spacer 450 exposed by the fourth opening when the processes illustrated with reference to FIGS. 16 and 17 are performed.

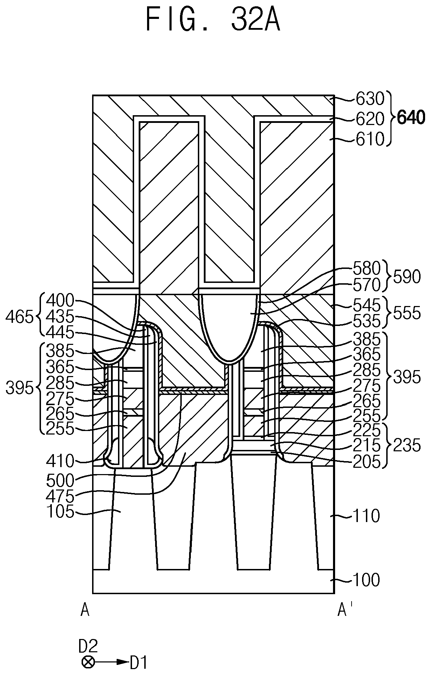

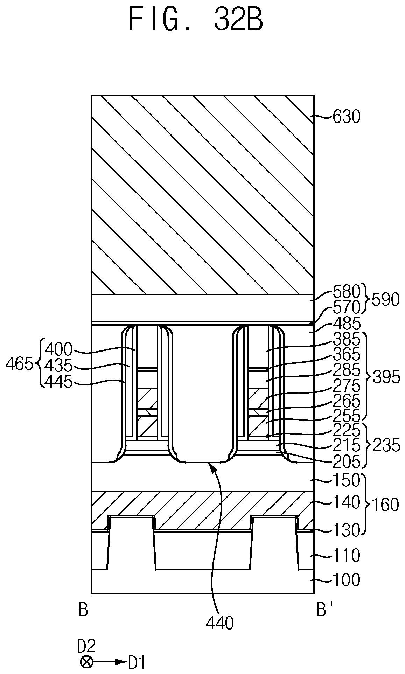

Referring to FIGS. 32A and 32B, the semiconductor device may not include the fifth insulation pattern 420. Accordingly, the fourth insulation pattern 410 may be formed in the first opening 240.

The fourth insulation pattern 410 in FIGS. 32A and 32B may be implemented by forming the fourth insulation layer, excluding the fifth insulation layer, on the first spacer layer, and anisotropically etching the fourth insulation layer, instead of sequentially forming the fourth and fifth insulation layers on the first spacer layer. The fourth insulation layer may be formed to fill the first opening 240.

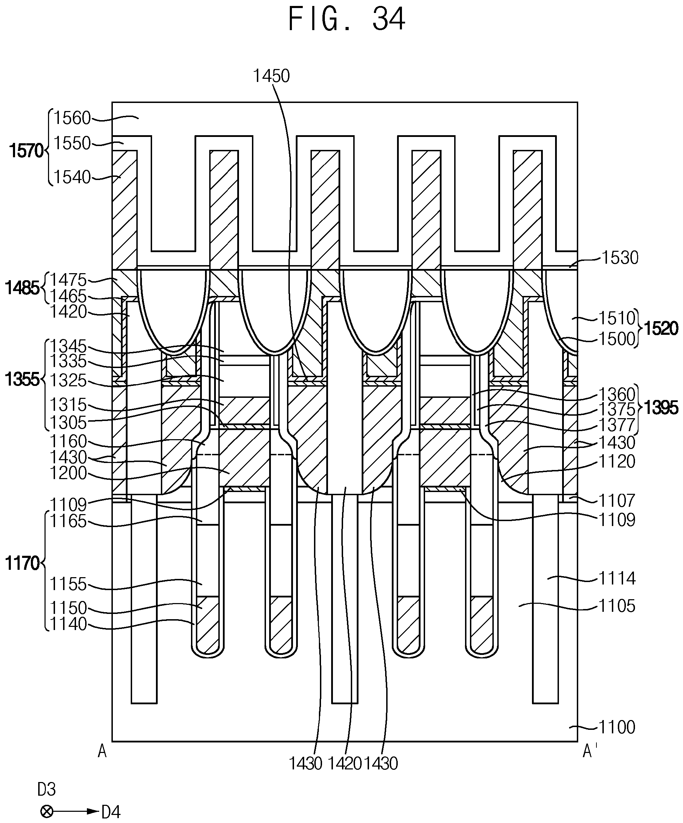

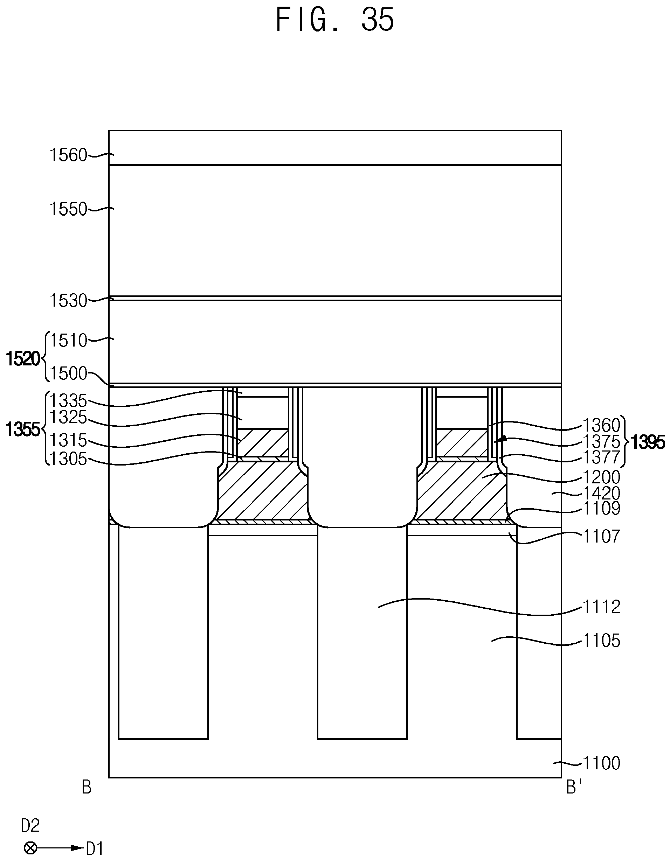

FIGS. 33 to 35 are a plan view and cross-sectional views illustrating semiconductor devices, according to embodiments. Specifically, FIG. 33 is the plan view, FIG. 34 is a cross-sectional view taken along line A-A' of FIG. 33, and FIG. 35 is a cross-sectional view taken along line B-B' of FIG. 33.

The semiconductor device may include elements substantially the same as or similar to those of FIGS. 1 to 4, and thus repeated explanations are omitted herein.

Referring to FIGS. 33 to 35, the semiconductor device may include a second active pattern 1105, a second gate structure 1170, a first conductive filling pattern 1200, a second bit line structure 1355, a second contact plug structure and a second capacitor 1570 on a second substrate 1100.

The semiconductor device may further include an isolation structure 1110, a second spacer structure 1395, first and second ohmic contact patterns 1109 and 1450, a second fence pattern 1420, first and second pads 1120 and 1160, a fourth insulation pattern structure 1520 and a fourth etch stop layer 1530.

The second active pattern 1105 and the isolation structure 1110 may correspond to the first active pattern 105 and the first isolation pattern 110, respectively, of FIGS. 1 to 4.

However, the isolation structure 1110 may include second and third isolation patterns 1112 and 1114. In embodiments, the second isolation pattern 1112 may extend in the fourth direction D4, and a plurality of the second isolation patterns 1112 may be spaced apart from each other in the first direction D 1. Additionally, the third isolation pattern 1114 may extend in the first direction D1, and be connected to the second isolation patterns 1112 disposed in the first direction D1. In embodiments, a plurality of third isolation patterns 1114 may be spaced apart from each other in the second direction D2.

In embodiments, the second active pattern 1105 may extend in the fourth direction D4 to a certain length, and a plurality of second active patterns 1105 may be spaced apart from each other in the fourth direction D4 by the third isolation pattern 1114. Additionally, a plurality of second active patterns 1105 may be spaced apart from each other in the first direction D1 by the second isolation pattern 1112. Accordingly, ones of the second active patterns 1105 disposed in the first direction D1 may be aligned to each other in the first direction D1. That is, corresponding end portions in the fourth direction D4 of the ones of the second active patterns 1105 disposed in the first direction D1 may be aligned to each other along the first direction D1.

The second active pattern 1105 may include a material substantially the same as a material of the second substrate 1100, and each of the second and third isolation patterns 1112 and 1114 may include, for example, an oxide such as silicon oxide. An impurity region 1107 including, for example, n-type impurities or p-type impurities may be formed at an upper portion of the second active pattern 1105.

The first pad 1120 may be formed on the second active pattern 1105 and the isolation structure 1110, and a plurality of first pads 1120 may be spaced apart from each other in the first and second directions D1 and D2. The first pad 1120 may include an oxide, e.g., silicon oxide.

The second gate structure 1170 may correspond to the first gate structure 170 of FIGS. 1 to 4

However, the second gate structure 1170 may extend in the first direction D1 through upper portions of the second active pattern 1105 and the isolation structure 1110 and through the first pad 1120. The second gate structure 1170 may include a third conductive pattern 1150, a fourth conductive pattern 1155, a second capping pattern 1165 sequentially stacked in the vertical direction and a second gate insulation pattern 1140. The second gate insulation pattern 1140 may be formed on sidewalls of the third conductive pattern 1150, the fourth conductive pattern 1155 and the second capping pattern 1165 and a lower surface of the third conductive pattern 1150. However, the second gate insulation pattern 1140 may not be formed on a portion of an upper sidewall of the second capping pattern 1165. The third and fourth conductive patterns 1150 and 1155 may collectively form a second gate electrode.

The second gate insulation pattern 1140 may include, for example, an oxide such as silicon oxide, the third conductive pattern 1150 may include, for example, a metal, a metal nitride, or a metal silicide, the fourth conductive pattern 1155 may include, for example, polysilicon doped with n-type impurities or p-type impurities, and the second capping pattern 1165 may include an insulating nitride such as silicon nitride.

In embodiments, the second gate structure 1170 may extend in the first direction D1, and a plurality of second gate structures 1170 may be spaced apart from each other in the second direction D2. Two of the second gate structures 1170 spaced apart from each other in the second direction D2 may extend through an upper portion of each of the second active patterns 1105. Each of the second active pattern 1105 extending in the fourth direction D4 may include a central portion between the two second gate structures 1170 adjacent to each other in the second direction D2, and end portions each of which may be disposed between a corresponding one of the two second gate structures 1170 and the third isolation pattern 1114.

In embodiments, a lower surface of the second gate structure 1170 may be at a higher level than a lower surface of the isolation structure 1110.

The second pad 1160 may disposed on the first pad 1120 and the second gate structure 1170, and a plurality of second pads 1160 may be spaced apart from each other in the first and second directions D1 and D2. The second pad 1160 may include, for example, an insulating nitride such as silicon nitride.

The first conductive filling pattern 1200 may be disposed on the second active pattern 1105 and the isolation structure 1110, and may extend through the first and second pads 1120 and 1160. The first conductive filling pattern 1200 may be disposed on the central portion of the second active pattern 1105.

The first ohmic contact pattern 1109 may be disposed between the impurity region 1107 at the upper portion of the second active pattern 1105 and the first conductive filling pattern 1200. The first ohmic contact pattern 1109 may include, for example, a metal silicide such as titanium silicide, cobalt silicide, nickel silicide, etc.

A plurality of first conductive filling patterns 1200 may be spaced apart from each other in the first and second directions D1 and D2. In embodiments, the first conductive filling pattern 1200 may include a lower portion and an upper portion stacked in the vertical direction. The lower portion of the first conductive filling pattern 1200 may extend through the first pad 1120, and the upper portion of the first conductive filling pattern 1200 may extend through the second pad 1160.

In embodiments, the lower portion of the first conductive filling pattern 1200 may contact sidewalls of the two second gate structures 1170 facing each other in the second direction D2. For example, the lower portion of the first conductive filling pattern 1200 may contact sidewalls of the first capping patterns 1165 facing each other in the second direction D2.

The first conductive filling pattern 1200 may include, for example, a metal, a metal nitride, etc.

The second bit line structure 1355 may include an adhesive pattern 1305, a fifth conductive pattern 1315, and a fourth mask 1325, a third etch stop pattern 1335 and a third capping pattern 1345 sequentially stacked on the first conductive filling pattern 1200 and the second pad 1160 in the vertical direction, which may correspond to the first barrier pattern 265, the second conductive pattern 275, the first mask 285, the first etch stop pattern 365 and the first capping pattern 385, respectively, of FIGS. 1 to 4.

The fourth mask 1325, the third etch stop pattern 1335 and the third capping pattern 1165 may collectively form a third insulation pattern structure. In some embodiments, the fourth mask 1325, the third etch stop pattern 1335 and the third capping pattern 1345 may include substantially the same material to be merged with each other, so that the third insulation pattern structure may have a single layer structure.

In embodiments, the second bit line structure 1355 may extend in the second direction D2 on the second substrate 1100, and a plurality of second bit line structures 1355 may be spaced apart from each other in the first direction D1. Each of the second bit line structures 1355 may contact an upper surface of the first conductive filling pattern 1200.

The second spacer structure 1395 may correspond to the first spacer structure 460 of FIGS. 1 to 4. Accordingly, the second spacer structure 1395 may include a fifth spacer 1360, an second air spacer 1375 and a seventh spacer 1377 sequentially stacked in the first direction D1 on each of opposite sidewalls of the second bit line structure 1355 in the first direction D1. The fifth spacer 1360, a second air spacer 1375 and a seventh spacer 1377 may correspond to the first spacer 400, the first air spacer 435 and the third spacer 445, respectively, of FIGS. 1 to 4.

However, the fifth spacer 1360 may be formed on each of opposite sidewalls of the second bit line structure 1355 in the first direction D1 and an upper surface of the second pad 1160, and accordingly, a cross-section in the first direction D1 of the fifth spacer 1360 may have an "L" shape. The second air spacer 1375 may be disposed on an outer wall of the fifth spacer 1360. The seventh spacer 1377 may be disposed on an outer wall of the second air spacer 1375 and a sidewall of the second pad 1160.

The second contact plug structure may correspond to the first contact plug structure of FIGS. 1 to 4. Accordingly, the second contact plug structure may include a second lower contact plug 1430, a second ohmic contact pattern 1450 and a second upper contact plug 1485 sequentially stacked on the second active pattern 1105 and the isolation structure 1110 in the vertical direction. The second lower contact plug 1430, the second ohmic contact pattern 1450 and the second upper contact plug 1485 may correspond to the first lower contact plug 575, the metal silicide pattern 500 and the first upper contact plug 555, respectively, of FIGS. 1 to 4.

However, the second lower contact plug 1430 may be disposed between the second spacer structures 1395 on respective opposite sidewalls of ones of the second bit line structures 1355 neighboring in the first direction D1, and a plurality of the second lower contact plugs 1430 may be spaced apart from each other in the second direction D2. Each of the second lower contact plugs 1430 may be disposed on a corresponding one of the opposite end portions of the second active pattern 1105, and may contact the impurity region 1107 disposed on the second active pattern 1105.

The second fence pattern 1420 may correspond to the first fence pattern 485 of FIGS. 1 to 4. Accordingly, the second fence pattern 1420 may be disposed between and separate ones of the second lower contact plugs 1430 neighboring in the second direction D2. That is, the second fence pattern 1420 may be disposed between the second spacer structures 1395 on respective opposite sidewalls of ones of the second bit line structures 1355 adjacent to each other in the first direction D1, and a plurality of second fence patterns 1420 may be spaced apart from each other in the second direction D2.

The second upper contact plug 1485 may include a second metal pattern 1475 and a third barrier pattern 1465 covering a lower surface thereof. The second metal pattern 1475 and the third barrier pattern 1465 may correspond to the first metal pattern 545 and the second barrier pattern 535, respectively, of FIGS. 1 to 4. Accordingly, the second upper contact plug 1485 may be disposed on the second ohmic contact pattern 1450, the second bit line structure 1355 and the second fence pattern 1420. In embodiments, the second upper contact plug 1485 may have a shape of such as a circle, an ellipse, a polygon, and a polygon with rounded corners in a plan view, and may be arranged, for example, in a honeycomb pattern in the first and second directions D1 and D2 in a plan view.

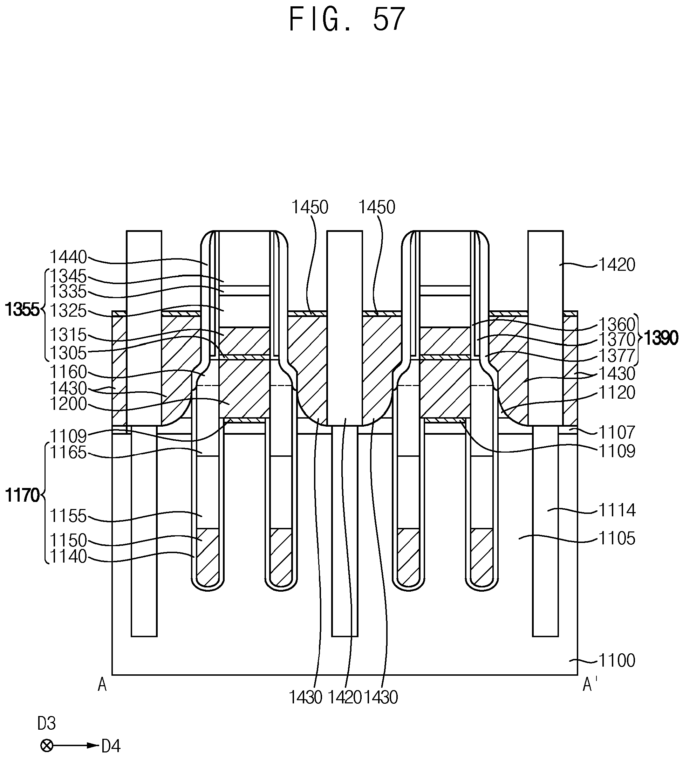

The fourth insulation structure 1520 may correspond to the second insulation structure 590 of FIGS. 1 to 4. Accordingly, referring to FIGS. 57 to 59 together with FIGS. 33 to 35, the fourth insulation pattern structure 1520 may include an eighth insulation pattern 1500 on an inner wall of a thirteenth opening 1490, which may extend through the second upper contact plug 1485, portions of the third insulation pattern structure included in the second bit line structure 1355 and the second upper spacer structure 1395, and surround the second upper contact plug 1485 in a plan view, and a ninth insulation pattern 1510 on the eighth insulation pattern 1500 and filling a remaining portion of the thirteenth opening 1490. An upper end of the second air spacer 1375 may be closed by the eighth insulation pattern 1500. The eighth and ninth insulation patterns 1500 and 1510 may correspond to the sixth and seventh insulation patterns, respectively, of FIGS. 1 to 4.

The fourth etch stop layer 1530 may correspond to the second etch stop layer 600 of FIGS. 1 to 4. Thus, the fourth etch stop layer 1530 may be disposed on the fourth insulation pattern structure 1520 and the second upper contact plug 1485.

The second capacitor 1570 may correspond to the firs capacitor 640 of FIGS. 1 to 4. Thus, the second capacitor 1570 may include a second lower electrode 1540, a second dielectric layer 1550 and a second electrode 1560 sequentially stacked. The second lower electrode 1540 may extend through the fourth etch stop layer 1430, and may contact an upper surface of the second upper contact plug 1485. The second lower electrode 1540, the second dielectric layer 1550 and the second upper electrode 1560 may correspond to the first lower electrode 610, the first dielectric layer 620 and the first upper electrode 630, respectively.

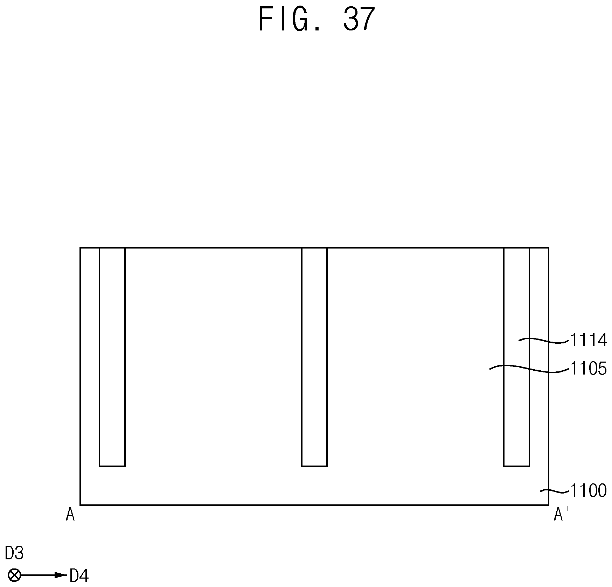

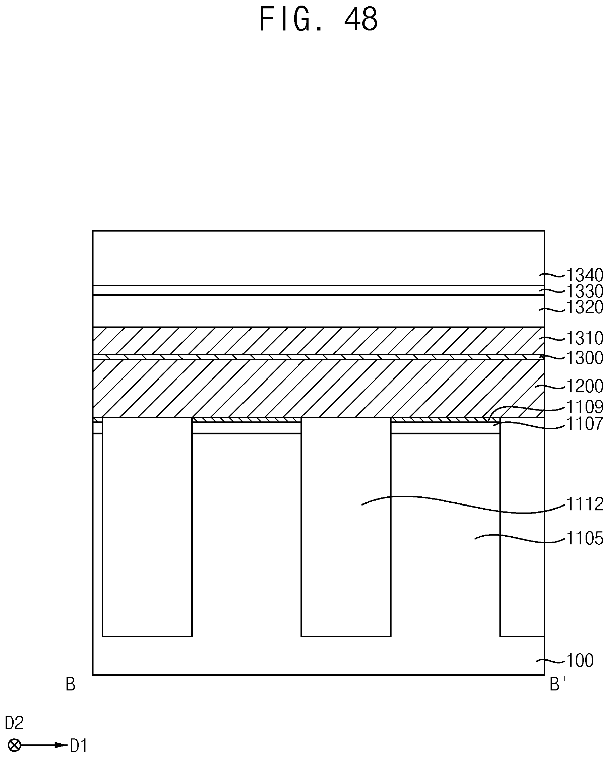

FIGS. 36 to 61 are plan views and cross-sectional views illustrating a method of manufacturing a semiconductor device, according to embodiments. Specifically, FIGS. 36, 38, 40, 43, 45, 49 and 60 are the plan views, FIGS. 37, 39, 41-42, 44, 46-47, 50, 52, 54, 56, 58-59 and 61 are cross-sectional views taken along lines A-A' of corresponding plan views, respectively, and FIGS. 48, 51, 53, 55 and 57 are cross-sectional views taken along lines B-B' of corresponding plan views respectively.

Referring to FIGS. 36 and 37, upper portions of a second substrate 1100 may be removed to form third and fourth recesses, and a second active pattern 1105 may be defined on the second substrate 1100.

An isolation structure 1110 may be formed to fill the third and fourth recesses, and a sidewall of the second active pattern 1105 may be covered by the isolation structure 1110.

In embodiments, the third recess may extend in the fourth direction D4, and a plurality of third recesses may be spaced apart from each other in the first direction D1. In addition, the fourth recess may extend in the first direction D1 to be connected to ones of the third recesses disposed in the first direction D1, and a plurality of fourth recesses may be spaced apart from each other in the second direction D2. The isolation structure 1110 may include second and third isolation patterns 1112 and 1114 in the third and fourth recesses, respectively, which may be connected to each other.

In embodiments, the second active pattern 1105 may extend to a certain length in the fourth direction D4, and a plurality of second active patterns 1105 may be spaced apart from each other in the fourth direction D4 by the third isolation pattern 1114. In addition, the plurality of second active patterns 1105 may be spaced apart from each other in the first direction D1 by the second isolation pattern 1112.

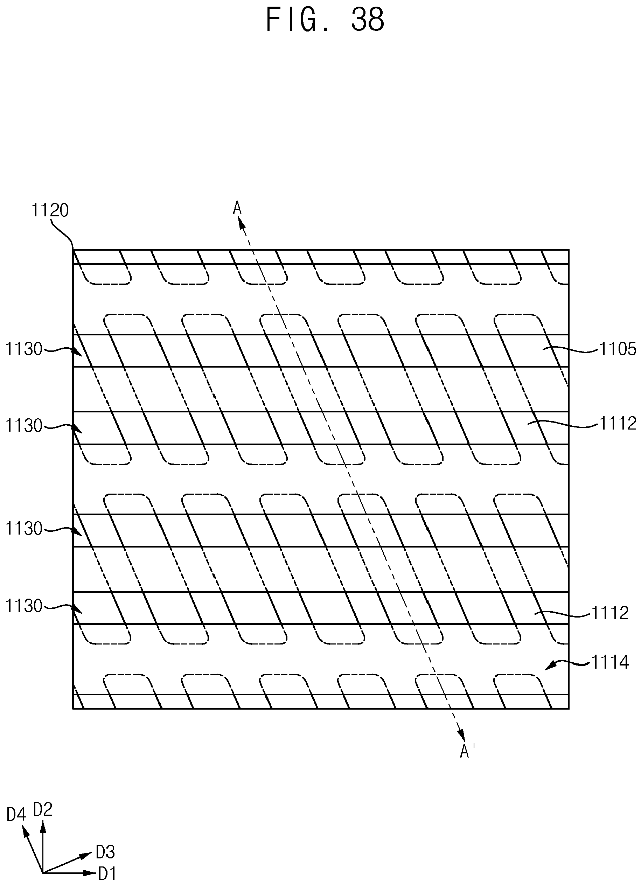

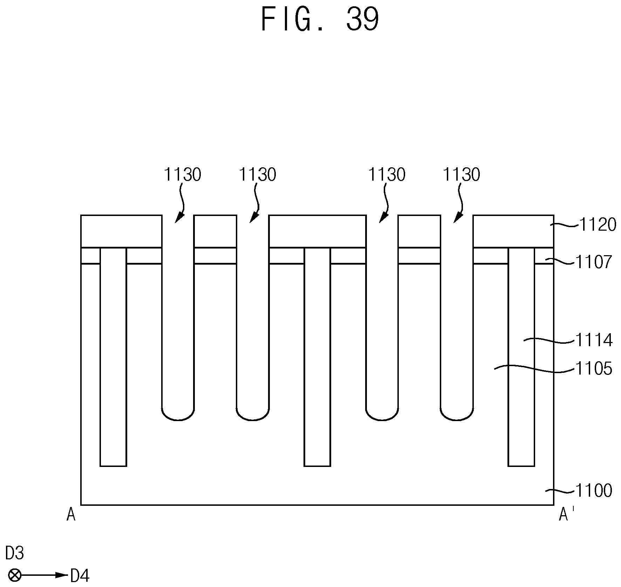

Referring to FIGS. 38 and 39, an impurity region 1107 may be formed at an upper portion of the second active pattern 1105 by doping, for example, n-type impurities or p-type impurities into the upper portion of the second active pattern 1105.

In embodiments, the impurity region 1107 may be formed by a gas phase doping (GPD) process.

A first pad layer may be formed on the second active pattern 1105 having the impurity region 1107 therein and the isolation structure 1110, the first pad layer may be patterned to form a first pad 1120, and the second active pattern 1105 may be partially etched using the first pad 1120 as an etching mask to form a fifth recess 1130.

The first pad 1120 may include, for example, an oxide such as silicon oxide.

In embodiments, the fifth recess 1130 may extend in the first direction D1, and a plurality of fifth recesses 1130 may be spaced apart from each other in the second direction D2. A bottom of each of the fifth recesses 1130 may be higher than a bottom surface of the isolation structure 1110.

In embodiments, two of the fifth recesses 1130 spaced apart from each other in the second direction D2 may be formed in each of the second active patterns 1105. Hereinafter, a portion of the second active pattern 1105 extending in the fourth direction D4 that may be disposed between the fifth recesses 1130 may be referred to as a central portion of the second active pattern 1105, and a portion of the second active pattern 1105 which may be disposed between each of the fifth recesses 130 and the third isolation pattern 1114 may be referred to as an end portion of the second active pattern 1105.

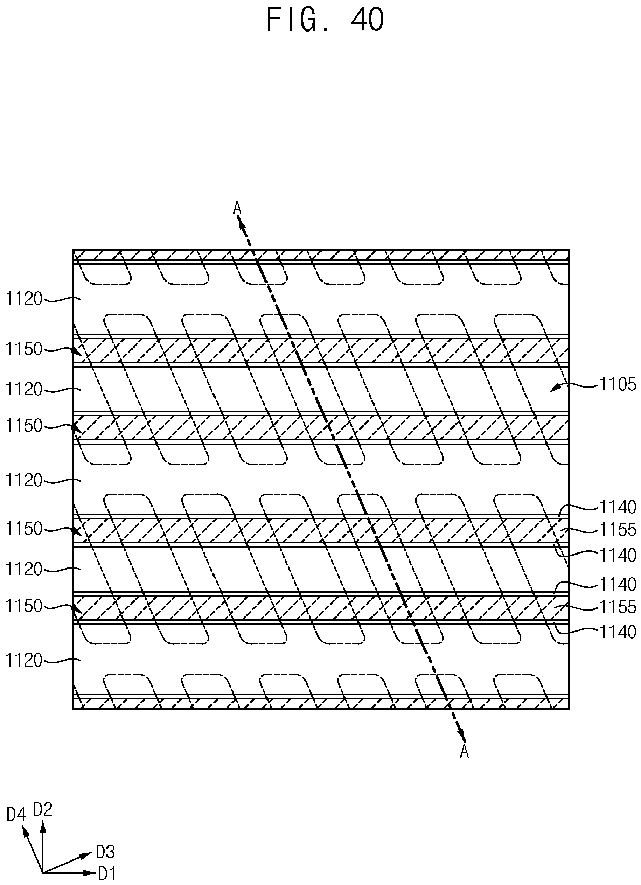

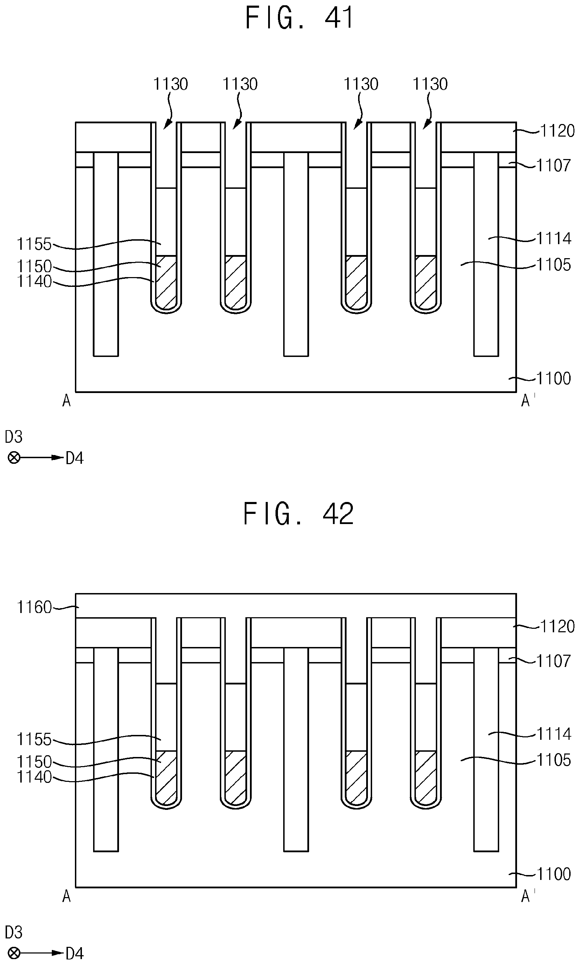

Referring to FIGS. 40 and 41, a second gate insulation layer may be formed on an inner wall of the fifth recess 1130 and an upper surface of the first pad 1120, and a portion of the second gate insulation layer on the upper surface of the first pad 1120 may be removed to form a second gate insulation pattern 1140 on the inner wall of the fifth recess 1130.

The second gate insulation pattern 1140 may be formed of, or may include, for example, an oxide such as silicon oxide.

A third conductive layer may be formed on the second gate insulation pattern 1140 and the first pad 1120, and an upper portion of the third conductive layer may be removed by, for example, an etch back process to form a third conductive pattern 1150 in a lower portion of the fifth recess 1130.

A fourth conductive layer may be formed on the third conductive pattern 1150, the second gate insulation pattern 1140 and the first pad 1120, and an upper portion of the fourth conductive layer may be removed by, for example, an etch back process to form a fourth conductive pattern 1155 in a central portion of the fifth recess 1130.

Referring to FIG. 42, a second capping layer 1160 may be formed on the fourth conductive pattern 1155, the second gate insulation pattern 1140 and the first pad 1120 to fill an upper portion of the fifth recess 1130. The second capping layer 1160 may include, for example, an insulating nitride such as silicon nitride.

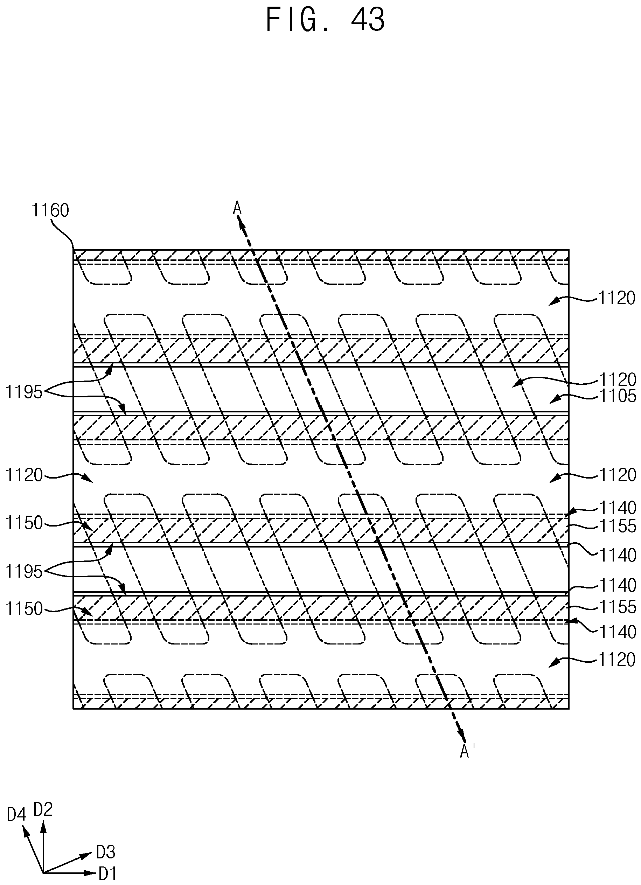

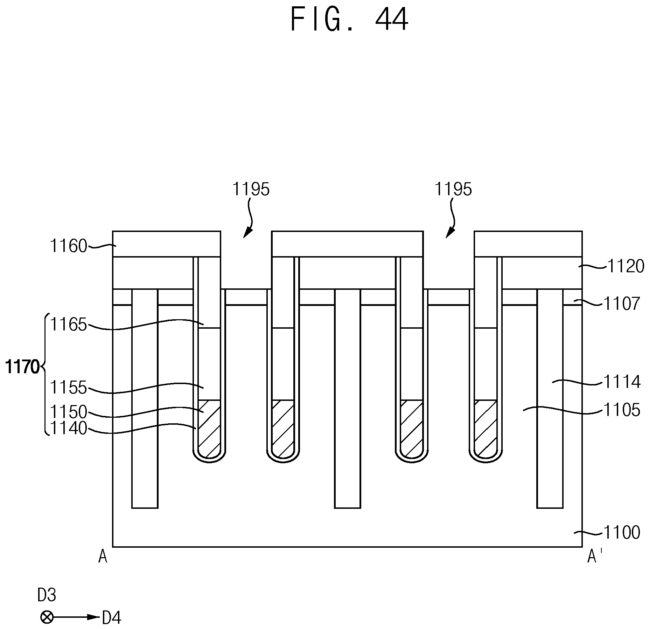

Referring to FIGS. 43 and 44, a third mask may be formed on the second capping layer 1160, and the second capping layer 1160 may be etched using the third mask as an etching mask to form an eighth opening exposing an upper surface of the first pad 1120.

In embodiments, the eighth opening may extend in the first direction D1, and a plurality of eighth openings may be spaced apart from each other in the second direction D2. Each of the eighth openings may overlap the central portions of corresponding ones of the second active patterns 1105 disposed in the first direction D1 in the vertical direction.

The portion of the first pad 1120 exposed by the eighth opening and an upper part of the portion of the second gate insulation pattern 1140 adjacent thereto in the second direction D2 may be removed through an etching process. Accordingly, the eighth opening may be enlarged to form a ninth opening 1195 exposing an upper surface of the impurity region 1107 at the upper portion of the second active pattern 1105 and an upper surface of the second gate insulating pattern 1140.

In embodiments, the etching process may include a wet etching process, and, the first pad 1120 and the second gate insulation pattern 1140 including, for example, an oxide such as silicon oxide may be partially removed, while the second capping layer 1160 including, for example, an insulating nitride such as silicon nitride may not be removed.

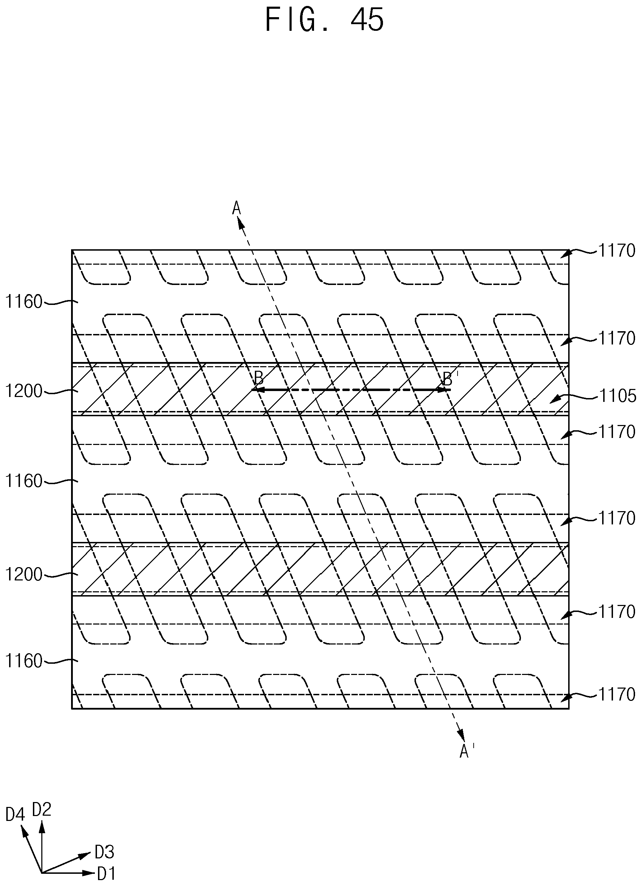

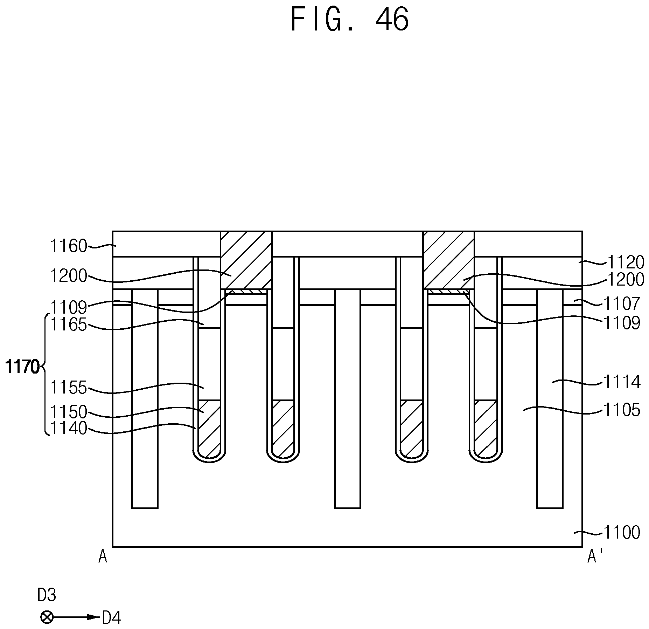

Referring to FIGS. 45 and 46, a first ohmic contact pattern 1109 may be formed on the upper surface of the impurity region 1107 exposed by the ninth opening 1195, and a first conductive filling pattern 1200 may be formed on the first ohmic contact pattern 1109 to fill a remaining portion of the ninth opening 1195.

The first ohmic contact pattern 1109 may be formed by forming a third metal layer on the upper surfaces of the impurity region 1107 and the second gate insulation pattern 1140 exposed by the ninth opening 1195, a sidewall of the ninth opening 1195 and an upper surface of the second capping layer 1160, and performing a heat treatment process on the third metal layer so that the metal included in the third metal layer and silicon included in the impurity region 1107 may react with each other, and a portion of the third metal layer that does not be react with silicon may be removed.

In embodiments, the first ohmic contact pattern 1109 may be formed on each of the second active patterns 1105 disposed in the first direction D1, and a plurality of first ohmic contact patterns 1109 may be spaced apart from each other in the first direction D1. In addition, a plurality of first ohmic contact patterns 1109 may be spaced apart from each other in the second direction D2.

The first conductive filling pattern 1200 may be formed by forming a fifth conductive layer on the first ohmic contact pattern 1109, the second gate insulation pattern 1140 and the third mask to fill the ninth opening 1195, and performing a planarization process on the fifth conductive layer until the upper surface of the second capping layer 1160 is exposed. During the planarization process, the third mask may be removed.

In embodiments, the first conductive filling pattern 1200 may extend in the first direction D 1, and a plurality of first conductive filling patterns 1200 may be spaced apart from each other in the second direction D2.

A portion of the second capping layer 1160, which may be formed on the fourth conductive pattern 1155, have a width substantially the same as a width of the second conductive pattern 1155, and have a sidewall on which the second gate insulation pattern 1140 is formed, may be referred to as a second capping pattern 1165, and an upper portion of the second capping pattern 1165 may contact a lower sidewall of the first conductive filling pattern 1200. The second gate insulation pattern 1140, and the third conductive pattern 1150, the fourth conductive pattern 1155 and the second capping pattern 1165, which may be sequentially stacked in the vertical direction on the second gate insulation pattern 1140 and have sidewalls in contact with an inner sidewall of the second gate insulation pattern 1140, may collectively form a second gate structure 1170.

Hereinafter, a portion of the second capping layer 1160 that does not form the second capping pattern 1165, in other words, a portion of the second capping layer 1160 on the first pad 1120, the second gate insulation pattern 1140 and the second capping pattern 1165, of which an upper surface is substantially coplanar with an upper surface of the first conductive filling pattern 1200, may be referred to as a second pad 1160.

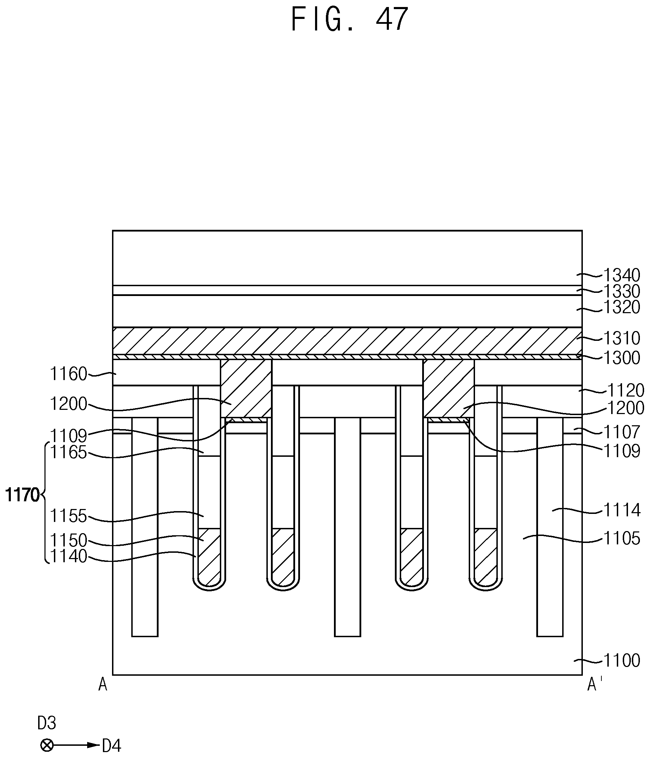

Referring to FIGS. 47 and 48, an adhesive layer 1300, a sixth conductive layer 1310, a fourth mask layer 1320, a third etch stop layer 1330 and a third capping layer 1340 may be sequentially stacked on the second pad 1160 and the first conductive filling pattern 1200.

Each of the fourth mask layer 320, the third etch stop layer 330 and the third capping layer 1340 may include an insulating nitride, such as silicon nitride. The fourth mask layer 1320, the third etch stop layer 1330 and the third capping layer 1340 may collectively form an insulation layer structure, and in some embodiments, may be merged with each other to form a single layer.

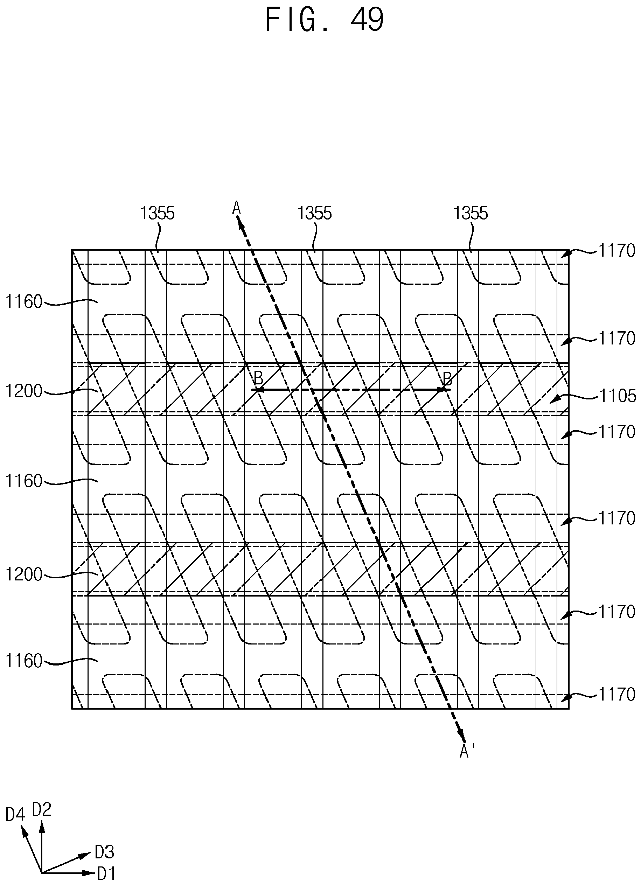

Referring to FIGS. 49 to 51, the third capping layer 1340 may be etched to form a third capping pattern 1345, and the third etch stop layer 1330, the fourth mask layer 1320, the sixth conductive layer 1310 and the adhesive layer 1300 may be sequentially etched by performing an etching process using the third capping pattern 1345 as an etch mask.

Accordingly, a second bit line structure 1355 extending in the second direction D2 may be formed on the first conductive filling pattern 1200 and the second pad 1160, and a plurality of second bit line structures 1355 may be spaced apart from each other in the first direction D1. Each of the second bit line structures 1355 may contact an upper surface of the first conductive filling pattern 1200 on the central portion of corresponding ones of the second active patterns 1105 disposed in the second direction D2.

The second bit line structure 1355 may include an adhesive pattern 1305, a fifth conductive pattern 1315, a fourth mask 1325, a third etch stop pattern 1335 and the third capping pattern 1345 sequentially stacked in the vertical direction. The fourth mask 1325, the third etch stop pattern 1335 and the third capping pattern 1345 may collectively form a third insulation pattern structure.

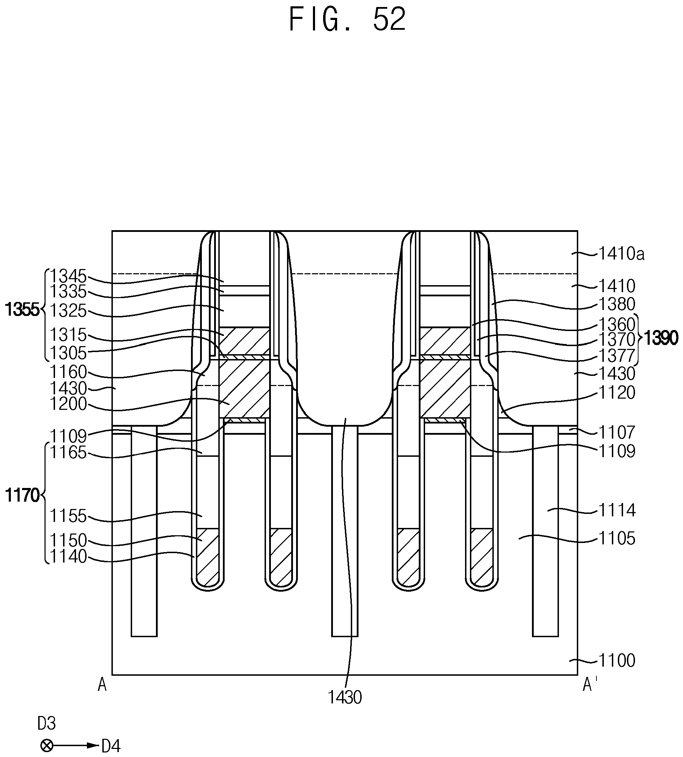

Referring to FIGS. 52 to 53, a fifth spacer layer may be formed on the second bit line structure 1355, the first conductive filling pattern 1200 and the second pad 1160, and a sixth spacer layer may be formed on the fifth spacer layer.

An anisotropic etching process may be performed on the fifth and sixth spacer layers to form fifth and sixth spacers 1360 and 1370, respectively, stacked along the first direction D1 on a sidewall of the second bit line structure 1355 in the first direction D1. A cross-section of the fifth spacer 1360 in the first direction D1 may have an "L" shape.

When the fifth and sixth spacers 1360 and 1370 are formed, a portion of the second pad 1160 on which the fifth and sixth spacers 1360 and 1370 and an upper portion of the first conductive filling pattern 1200 are not formed may also be removed, and accordingly, an upper surface of the first pad 1120 and an upper surface of a lower portion of the first conductive filling pattern 1200 may be exposed.

A seventh spacer layer and a second protective spacer layer may be formed on the second bit line structure 1355, the fifth and sixth spacers 1360 and 1370, the first conductive filling pattern 1200 and the first pad 1120, and an anisotropic etching process may be performed thereon to form a seventh spacer 1377 and a second protective spacer 1380, respectively.

Accordingly, a second preliminary spacer structure 1390 including fifth to seventh spacers 1360, 1370 and 1377 sequentially stacked in the first direction D1 may be formed on the sidewall of the second bit line structure 1355 in the first direction D1, and a second protective spacer 1380 may be formed on an outer sidewall of the second preliminary spacer structure 1390.

The seventh spacer 1377 may include, for example, nitride such as silicon nitride. In embodiments, the second protective spacer 1380 may include a material having a high etching selectivity with respect to that of a second sacrificial layer that may be formed subsequently, such as, a metal nitride such as titanium nitride (TiN), or a low-k material such as silicon oxycarbide (SiOC), silicon oxycarbonitride (SiOCN), etc.

When the seventh spacer 1377 and the second protective spacer 1380 are formed, the first pad 1120 and the lower portion of the first conductive filling pattern 1200 on which the second preliminary spacer structure 1390 is not formed, and the first ohmic contact 1109 under the first conductive filling pattern 1200 may also be removed, and the upper surface of the impurity region 1107 at the upper portion of the second active pattern 1105 and an upper surface of the isolation structure 1110 adjacent thereto may be exposed.

A second sacrificial layer may be formed to a sufficient height on the second bit line structure 1355, the second preliminary spacer structure 1390, the second active pattern 1105 and the isolation structure 1110, and may be planarized until an upper surface of the second bit line structure 1355 is exposed to form a second sacrificial pattern 1410.

In embodiments, the second sacrificial pattern 1410 may extend in the second direction D2, and a plurality of second sacrificial patterns 1410 may be spaced apart from each other by the second bit line structures 1355 in the first direction D1. The second sacrificial pattern 1410 may include, for example, an oxide such as silicon oxide.

An ion implantation process may be performed on the second sacrificial pattern 1410 so that an upper portion of the second sacrificial pattern 1410 may be doped with ions, e.g., helium (He) ions. Accordingly, an ion-containing region 1410a which may be relatively resistant to etching processes may be formed at the upper portion of the second sacrificial pattern 1410.

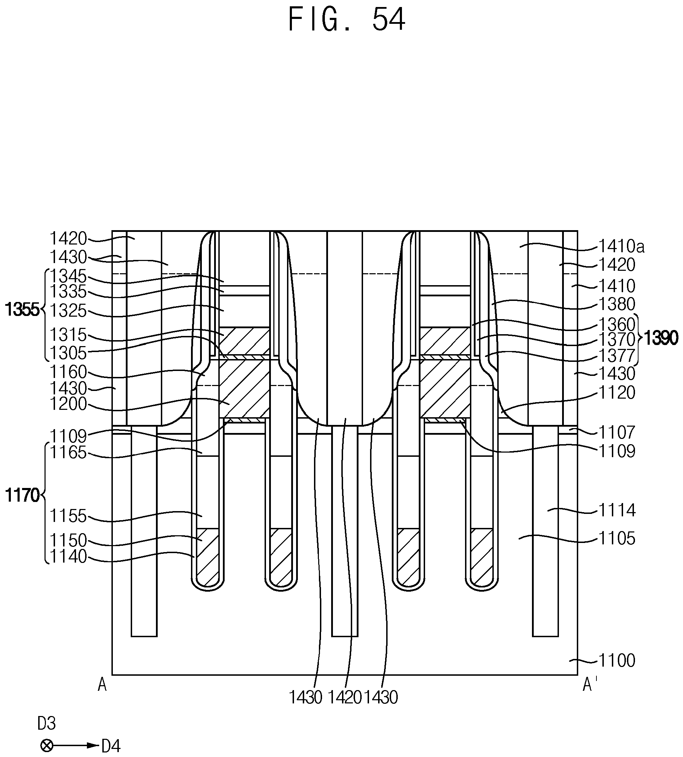

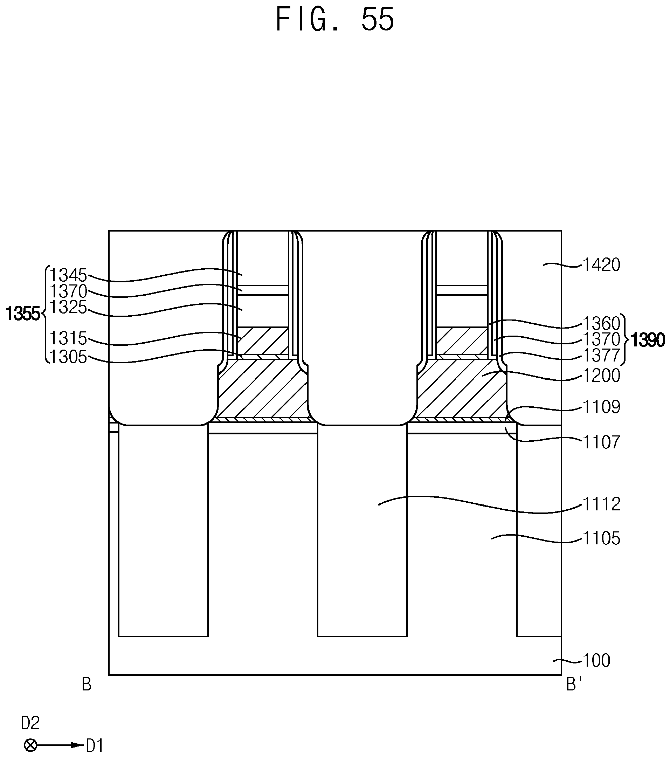

Referring to FIGS. 54 and 55, a fifth mask having a plurality of tenth openings spaced apart from each other in the second direction D2, each of which may extend in the first direction D1, may be formed on the second bit line structure 1355, the second preliminary spacer structure 1390 and the second sacrificial pattern 1410, and the second sacrificial pattern 1410 may be etched using the fifth mask as an etching mask.

In embodiments, each of the tenth openings may overlap in the vertical direction the central portions of corresponding ones of the second active patterns 1105 and portions of the third isolation pattern 1114 adjacent thereto in the first direction D 1. By the etching process, an eleventh opening exposing the upper surfaces of the second active pattern 1105 and the isolation structure 1110 between ones of the second bit line structures 1355 adjacent to each other in the first direction D1 may be formed on the second substrate 1100.

After removing the fifth mask, a portion of the second protective spacer 1380 exposed by the eleventh opening may be removed, and accordingly, a width in the first direction D1 of the eleventh opening may be enlarged.

A second fence layer may be formed to fill the eleventh opening to a sufficient height, and an upper portion of the second fence layer may be planarized until the upper surface of the second bit line structure 1355 is exposed. Accordingly, the second fence layer may be transformed into a plurality of second fence patterns 1420 spaced apart from each other in the second direction D2 between the second bit line structures 1355. The second fence pattern 1380 may include an insulating nitride, e.g., silicon nitride.

Additionally, the second sacrificial pattern 1410 extending in the second direction D2 between the second bit line structures 1355 may be separated into a plurality of parts spaced apart from each other in the second direction D2 by the second fence patterns 1420.

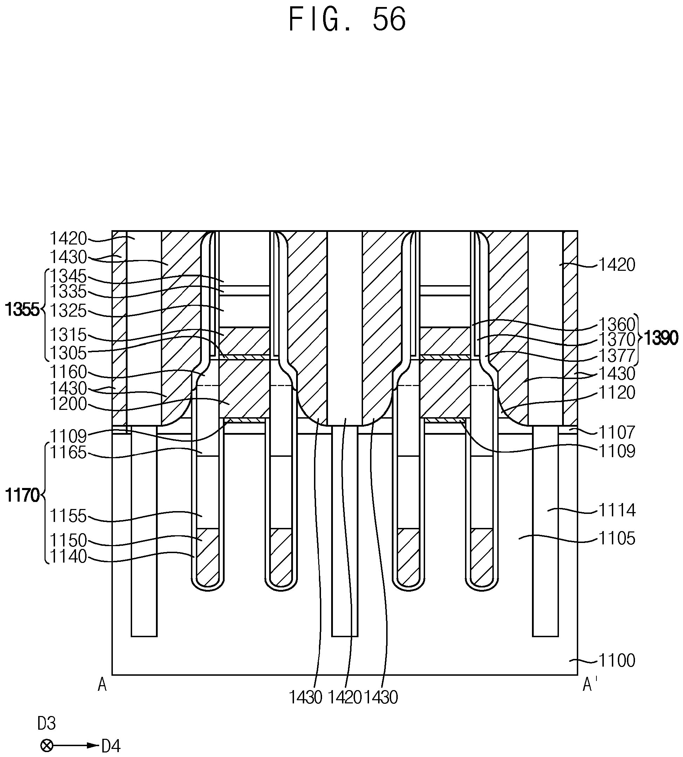

Referring to FIG. 56, the second sacrificial pattern 1410 may be removed to form a twelfth opening, and a portion of the second protective spacer exposed by the twelfth opening may be removed. Accordingly, a width in the first direction D1 of the twelfth opening may be enlarged.

A second lower contact plug 1430 may be formed in the twelfth opening. In embodiments, a plurality of second lower contact plugs 1430 may be spaced apart from each other in the second direction D2 by second fence patterns 1420 between the second bit line structures 1355, and each of the second lower contact plugs 1430 may contact the upper surface of the impurity region 1107 at the upper portion of a corresponding one of opposite end portions in the fourth direction D4 of the second active pattern 1105.

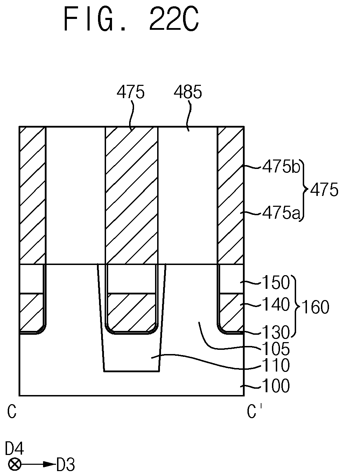

As described with reference to FIGS. 21 and 22 , the second lower contact plug 1430 may be formed by an epitaxial growth process, using the second active pattern 1105 exposed by the twelfth opening as a seed, and/or a deposition process, and a planarization process may be further performed thereon. In addition, a heat treatment process such as a melting laser annealing (MLA) process may be performed on the second lower contact plug 1430.

Referring to FIG. 57, an upper portion of the second contact plug 1430 may be removed, and a second ohmic contact pattern 1450 may be formed on an upper surface of the second lower contact plug 1430.

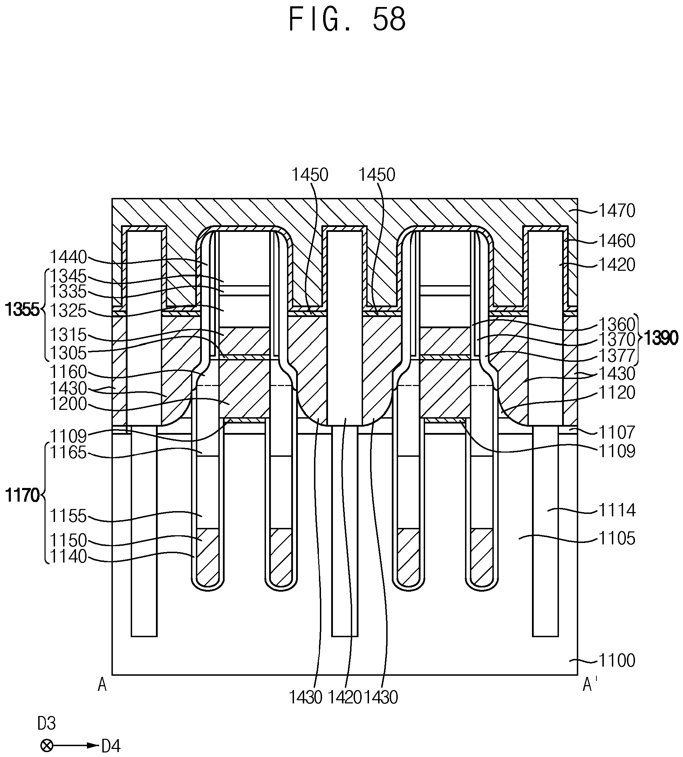

Referring to FIG. 58, a third barrier layer 1460 may be formed on the second bit line structure 1355, the second preliminary spacer structure 1390, the second fence pattern 1420 and the second ohmic contact pattern 1450, and a fifth metal layer 1470 may be formed on the third barrier layer 1460 to fill a space between the second bit line structures 1355.

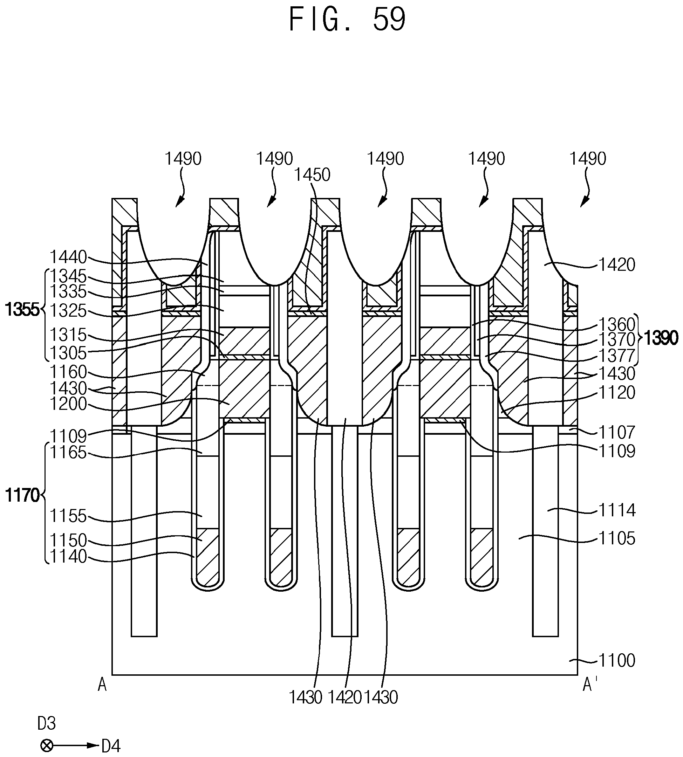

Referring to FIG. 59, the fifth metal layer 1470 and the third barrier layer 1460 may be patterned to form a second upper contact plug 1485, and a thirteenth opening 1490 may be formed between the second upper contact plugs 1485.

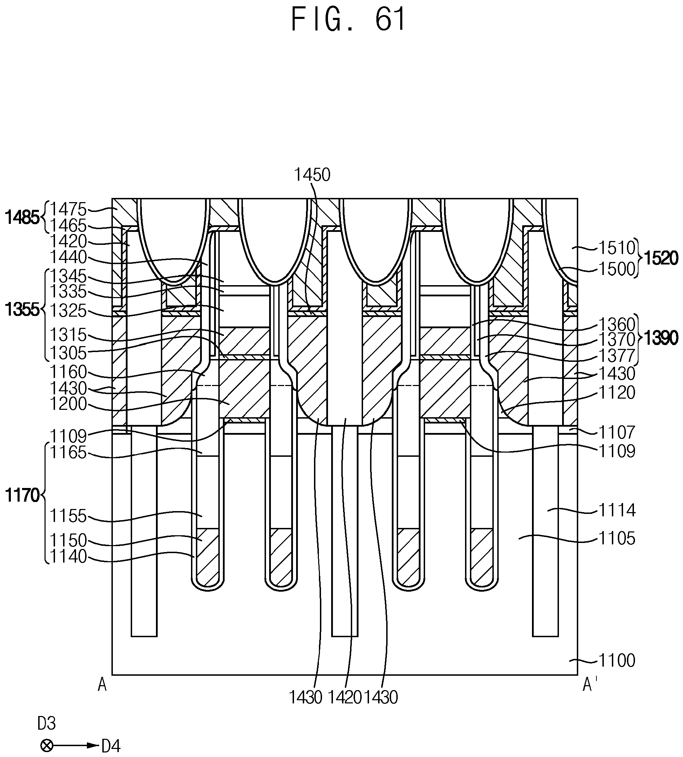

The second upper contact plug 1485 may include a second metal pattern 1475 and a third barrier pattern 1465 covering a lower surface thereof (see figure 61). The second lower contact plug 1430, the second ohmic contact pattern 1450 and the second upper contact plug 1485 sequentially stacked on the second substrate 1100 may collectively form a second contact plug structure.

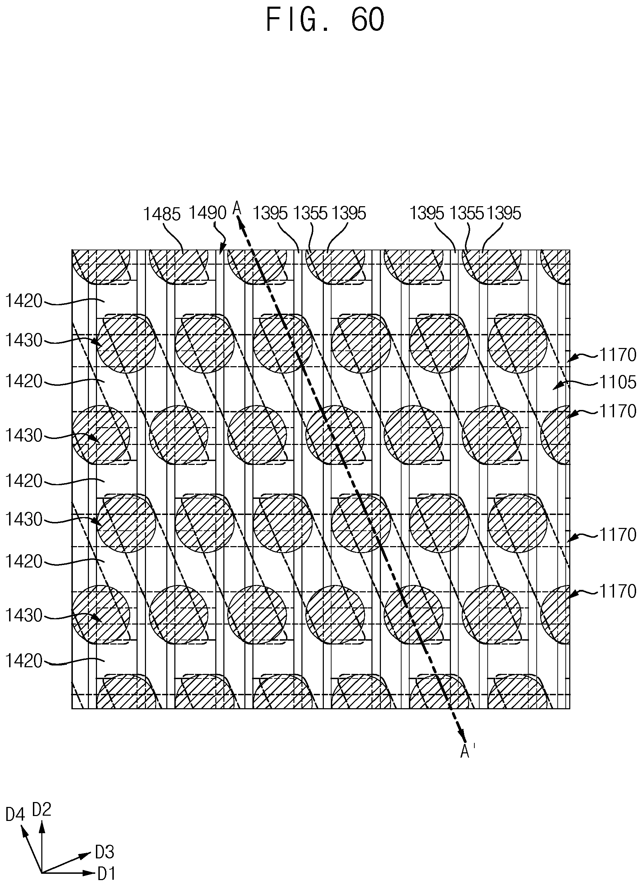

Referring to FIGS. 60 and 61, the sixth spacer 1370 included in the preliminary spacer structure 1390 exposed by the thirteenth opening 1490 may be removed to form an air gap, an eighth insulation pattern 1500 may be formed on a bottom and a sidewall of the thirteenth opening 1460, and a ninth insulation pattern 1510 may be formed in a remaining portion of the thirteenth opening 1490.

The eighth and ninth insulation patterns 1500 and 1510 may collectively form a fourth insulation pattern structure 1520.

On an upper end of the air gap may be formed the eighth insulation pattern 1500, so that a second air spacer 1375 may be formed. The fifth spacer 1360, the second air spacer 1375 and the seventh spacer 1377 may collectively form a second spacer structure 1395.

However, in some embodiments, the sixth spacer 1370 need not be removed, and in this case, instead of the second spacer structure 1395 including the second air spacer 1375, the second preliminary spacer structure 1390 including the sixth spacer 1370 may remain.

Referring back to FIGS. 33 to 35, a fourth etch stop layer 1530 and a mold layer may be sequentially formed on the fourth insulation pattern structure 1520 and the second upper contact plug 1485, a fourteenth opening may be formed through the mold layer and the fourth etch stop layer 1530 to expose an upper surface of the second upper contact plug 1485, and a second lower electrode 1540 may be formed in the fourteenth opening.

The mold layer may be removed, and a second dielectric layer 1550 and a second upper electrode 1560 may be sequentially formed on the second lower electrode 1540 and the fourth etch stop layer 1530. Thus, a second capacitor 1570 including the second lower electrode 1540, the second dielectric layer 1550 and the second upper electrode 1560 may be formed, and the fabrication of the semiconductor device may be completed.

FIG. 62 is a cross-sectional view illustrating a semiconductor device, according to embodiments. This semiconductor device may be substantially the same as or similar to that of FIGS. 33 to 35, except for some elements, and thus repeated explanations are omitted herein.

Referring to FIG. 62, an eighth spacer 1440 may be further formed, which may correspond to the fourth spacer 490 of FIGS. 1 to 4. Accordingly, the eighth spacer 1440 may be formed on an upper portion of an outer sidewall of the fifth spacer 1360, and may be formed on the upper end of the second air spacer 1375 and the upper surface of the seventh spacer 1377.

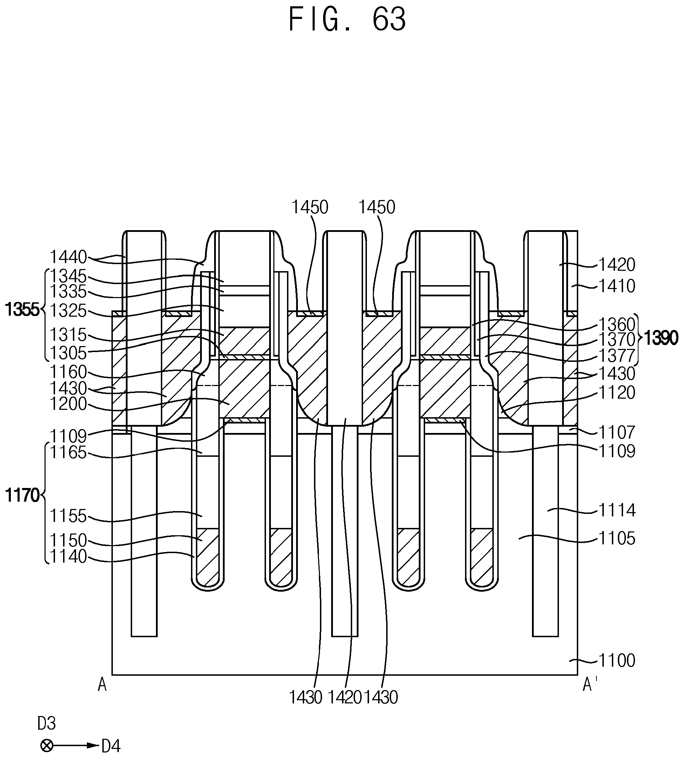

FIG. 63 is a cross-sectional view illustrating a method of manufacturing a semiconductor device, according to embodiments. This method may include processes substantially the same as or similar to those illustrated with reference to FIGS. 36 to 61 and FIGS. 33 to 35, and thus repeated explanations are omitted herein.

Referring to FIG. 63, processes substantially the same as or similar to those illustrated with reference to FIG. 57 may be performed.

However, after removing an upper portion of the second lower contact plug 1430 to expose an upper portion of the second preliminary spacer structure 1390 on the sidewall of the second bit line structure 1355, upper portions of the sixth and seventh spacer structure 1370 and 1377 of the exposed second preliminary spacer structure 1390 may be removed.

An upper portion of the second lower contact plug 1430 may be additionally removed. Thus, an upper surface of the second lower contact plug 1430 may be lower than upper surfaces of the sixth and seventh spacers 1370 and 1377.

An eighth spacer layer may be formed on the second bit line structure 1355, the second preliminary spacer structure 1390, the second fence pattern 1420 and the second lower contact plug 1430, and may be anisotropically etched to form an eighth spacer 1440 on an upper portion of the second preliminary spacer structure 1390 on the sidewall of the second bit line structure 1355, and the upper surface of the second lower contact plug 1430 may be exposed by the etching process.

A second ohmic contact pattern 1450 may be formed on the exposed upper surface of the second lower contact plug 1430.

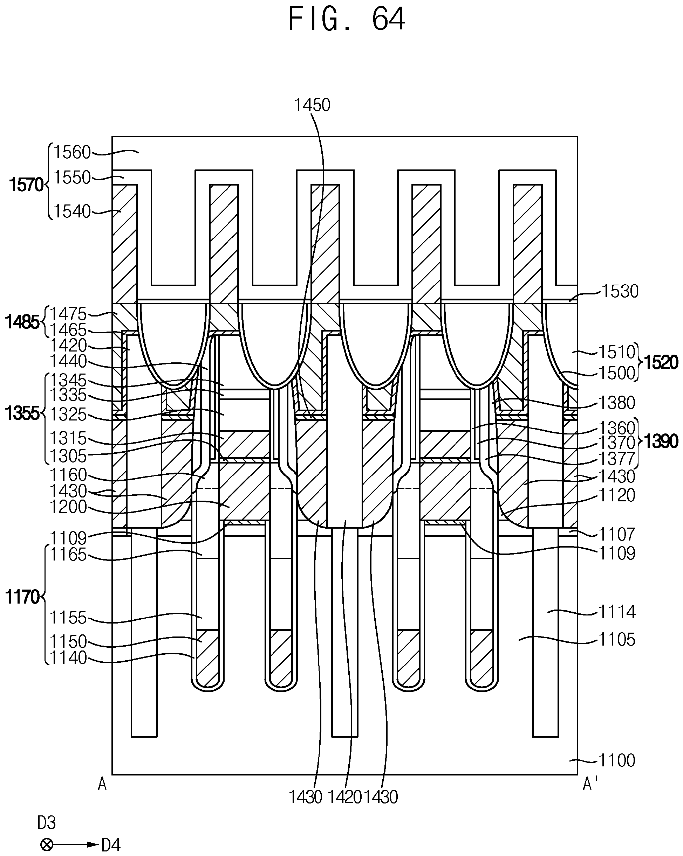

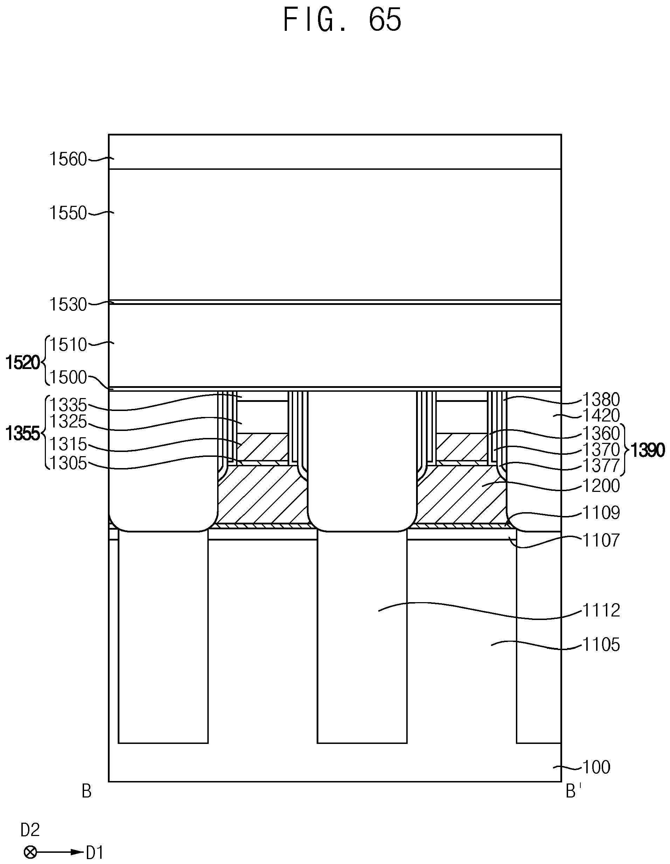

FIGS. 64 and 65 are cross-sectional views illustrating semiconductor devices, according to embodiments. These semiconductor devices may be substantially the same as or similar to that of FIGS. 33 to 35, except for some elements, and thus repeated explanations are omitted herein.

Referring to FIG. 64, the second protective spacer 1380 may be additionally formed on an outer sidewall of the seventh spacer 1377, and contact the second lower contact plug 1430.

Referring to FIG. 65, the second protective spacer 1380 may be additionally formed on an outer sidewall of the seventh spacer 1377, and contact the second fence pattern 1420.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the present inventive concept. Accordingly, all such modifications are intended to be included within the scope of the disclosure as defined in the claims. In the claims, means-plus-function clauses are intended to cover the structures described herein as performing the recited function and not only structural equivalents but also equivalent structures. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A semiconductor device comprising:
an active pattern on a substrate;
a gate structure in an upper portion of the active pattern;
a bit line structure on the active pattern;
a spacer structure on a sidewall of the bit line structure, the spacer structure comprising an insulating material; and
a lower contact plug on a portion of the active pattern adjacent to the bit line structure, the lower contact plug contacting the spacer structure,
wherein the spacer structure comprises a layer having at least two curves and a vertex disposed between and contacting the two curves.

2. The semiconductor device according to claim 1, wherein the spacer structure comprises a first spacer, a second spacer and a third spacer sequentially stacked on the sidewall of the bit line structure, and
wherein the layer having the two curves and the vertex comprises the third spacer.

3. The semiconductor device according to claim 2, wherein an end portion in a vertical direction of the third spacer comprises the two curves and the vertex, the vertical direction being perpendicular to an upper surface of the substrate.

4. The semiconductor device according to claim 1, 2, or 3, further comprising a protective spacer which contacts an outer sidewall of the spacer structure, and
wherin the protective spacer comprises at least one of titanium nitride (TiN), silicon oxycarbide (SiOC), and silicon oxycarbonitride (SiOCN).

5. The semiconductor device according to any one of claims 1 to 4, wherein the bit line structure is one of a plurality of bit line structures spaced apart from each other in a first direction, and the lower contact plug is one of a plurality of lower contact plugs spaced apart from each other in a second direction parallel to the upper surface of the substrate and intersecting the first direction, and
wherein the semiconductor device further comprises a fence pattern that is disposed between and separates ones of the plurality of lower contact plugs neighboring in the second direction.

6. The semiconductor device according to claim 5, wherein the fence pattern contacts the spacer structure.

7. The semiconductor device according to any one of claims 1 to 6, further comprising an isolation pattern on a sidewall of the active pattern,
wherein an upper surface of a portion of the active pattern directly contacting the lower contact plug is higher than an upper surface of a portion of the isolation pattern directly contacting the lower contact plug.

8. The semiconductor device according to any one of claim 1 to 7, further comprising:
an upper contact plug on the lower contact plug; and
a capacitor on the upper contact plug.

9. The semiconductor device according to any one of claims 1 to 8, wherein a slope of the layer of the spacer structure changes from a negative value to a positive value at the vertex.

10. The semiconductor device according to any one of claims 1 to 9, wherein a slope of the layer of the spacer structure non-linearly changes at the vertex.

11. A method of manufacturing a semiconductor device, the method comprising:
forming active patterns on a substrate in first and second directions parallel to an upper surface of the substrate and perpendicular to each other;
forming gate structures spaced apart from each other in the second direction, each of the gate structures formed in an upper portion of the active patterns and extending in the first direction;
forming bit line structures on ones of the active patterns disposed in the second direction to be spaced apart from each other in the first direction, each of the bit line structures extending in the second direction;
forming spacer structures on sidewalls of the bit line structures, respectively;
forming a sacrificial pattern between the spacer structures;
doping ions into an upper portion of the sacrificial pattern;
performing an etching process on the sacrificial pattern to form first openings spaced apart from each other in the second direction, the first openings exposing upper surfaces of corresponding ones of the gate structures, respectively;
forming fence patterns in the first openings, respectively;
removing the sacrificial pattern to form second openings, the second openings exposing upper surfaces of corresponding ones of the active patterns, respectively; and
forming lower contact plugs in the second openings, respectively.

12. The method according to claim 11, wherein doping the ions into the upper portion of the sacrificial pattern comprises performing an ion implantation process using helium (He) ions.

13. The method according to claim 11 or 12, wherein the sacrificial pattern comprises silicon oxide or an organic material having an etching selectivity with respect to the fence pattern.

14. The method according to claim 11, 12, or 13, further comprising forming a protective spacer on a sidewall of each of the spacer structures.

15. The method according to claim 14, wherein the protective spacer comprises a material resistant to a dry etching process.
